**Europäisches Patentamt**

**European Patent Office**

**Office européen des brevets**

(19)

(11) **EP 1 365 413 A2**

(12) **EUROPÄISCHE PATENTANMELDUNG**

(43) Veröffentlichungstag:
**26.11.2003 Patentblatt 2003/48**

(51) Int Cl.⁷: **G11C 7/06**, G11C 11/419

(21) Anmeldenummer: **03009201.9**

(22) Anmeldetag: **22.04.2003**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(30) Priorität: **02.05.2002 DE 10219649**

(71) Anmelder: **Infineon Technologies AG
81669 München (DE)**

(72) Erfinder:
• **Larguier, Yean-Yves Michel
06600 Antibes (FR)**

• **Schmitt-Landsiedel, Doris
85521 Ottobrunn (DE)**
• **Wicht, Bernhard, Park Side
Farmers Branch, Texas 75244 (US)**

(74) Vertreter: **Graf Lambsdorff, Matthias, Dr.
Patentanwälte
Lambsdorff & Lange
Dingolfinger Strasse 6
81673 München (DE)**

(54) **Differentielle Strombewerterschaltung und Leseverstärkerschaltung zum Bewerten eines Speicherzustands einer SRAM-Halbleiterspeicherzelle**

(57) Eine differentielle Strombewerterschaltung (SBS) weist einen Differenzverstärker (DV) und Mittel (MIN, MINB) zum Einstellen des Eingangswiderstands der Strombewerterschaltung (SBS) auf. Diese Mittel (MIN, MINB) sind mit den Ausgängen (outp, outn) und den Eingängen (inn, inp) des Differenzverstärkers (DV) und mit Signalleitungen (BL, BLB), mit denen auch die Eingänge (inn, inp) des Differenzverstärkers (DV) elektrisch verbunden sind, verbunden. Eine Leseverstärkerschaltung (LV) weist einen Schaltungsteil (ST2) auf, welcher derart aufgebaut ist, dass ein Signal am Ausgang der Leseverstärkerschaltung (LV) zeitlich kontinuierlich zur Verfügung gestellt werden kann, auch wenn nach dem Deaktivieren der vorgeschalteten Schaltung, insbesondere der Strombewerterschaltung (SBS), an seinem Eingang kein, insbesondere von der Strombewerterschaltung, geliefertes Signal mehr anliegt. Die differentielle Strombewerterschaltung (SBS) und die Leseverstärkerschaltung (LV) sind in einer Schaltungsanordnung zum Auslesen und Bewerten eines Speicherzustandes einer Halbleiterspeicherzelle angeordnet. Die Strombewerterschaltung kann durch einen Schaltungsteil zum automatischen Deaktivieren (STAD) vor einem Lesevorgang aktiviert und unmittelbar nach Beenden des Lesevorgangs automatisch deaktiviert werden.

Fig. 8

## Beschreibung

Differentielle Strombewerterschaltung und Leseverstärkerschaltung zum Bewerten eines Speicherzustands einer SRAM-Halbleiterspeicherzelle

Die Erfindung betrifft eine insbesondere in einer Halbleiterspeichervorrichtung verwendete differentielle Strombewerterschaltung. Des Weiteren betrifft die Erfindung eine Leseverstärkerschaltung zum Bewerten einer Spannungsdifferenz zwischen Signalleitungen, insbesondere zum Auslesen und Bewerten deiner Spannungsdifferenz zwischen zwei Signalleitungen welche mit einer Halbleiterspeicherzelle verbunden sind.

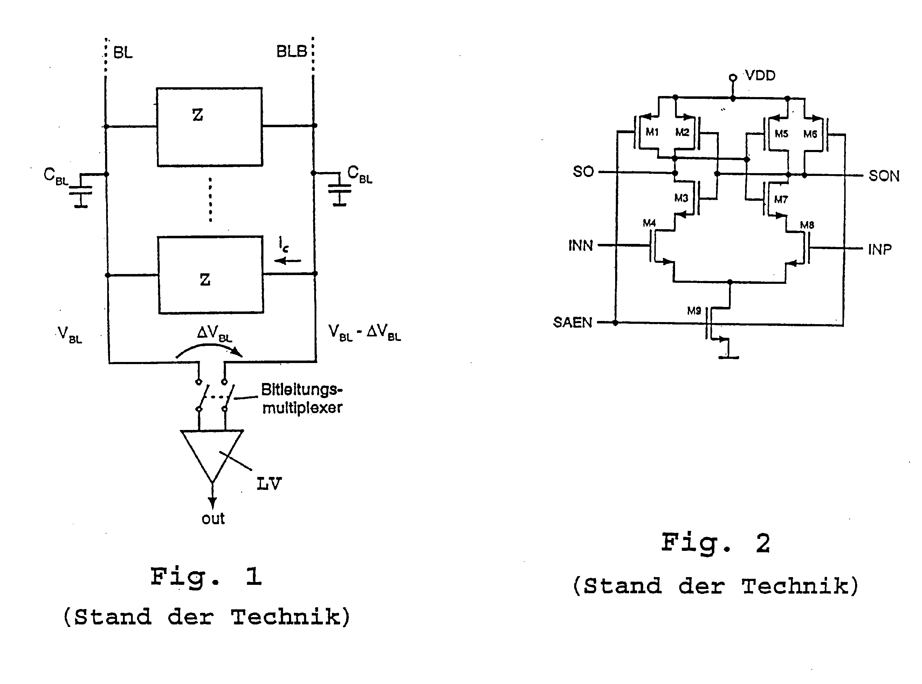

Halbleiterspeicherzellen wie beispielsweise statische Speicher (SRAM) werden in integrierten Schaltungen vielfach angewendet. SRAMs werden sowohl als Einzelbausteine hergestellt als auch zusätzlich zu anderen Bauelementen auf einem Chip integriert. Der Flächenanteil von SRAMs in Mikroprozessoren und in anderen hoch komplexen Logikschaltungen beträgt bis zu 50%. Daher ist ein sorgfältiger Entwurf des SRAMs sowie der Peripherieschaltungen in vielen Anwendungsfällen von großer Bedeutung. Ein SRAM ist ein Schreib-Lese-Speicher mit wahlfreiem Zugriff. Man spricht von einem statischen Speicher, da die elektrisch eingeschriebene Information unbegrenzt gespeichert werden kann, solange die Versorgungsspannung nicht abgeschaltet wird. Eine bekannte SRAM-Speicherzelle besteht aus zwei rückgekoppelten CMOS-Invertern, die über zwei NMOS-Auswahltransistoren mit den beiden komplementären Bitleitungen verbunden sind. Durch die Verwendung komplementärer Bitleitungen wird die Zuverlässigkeit erhöht und die Empfindlichkeit gegenüber Schwankungen der Bauteilkenngrößen verringert. Fig. 1 zeigt eine bekannte Schaltungsanordnung zum Auslesen und Bewerten eines Speicherzustands in einer Halbleiterspeicherzelle, insbesondere einer SRAM-Speicherzelle. Die Speicherzellen Z sind über ein Bitleitungspaar BL und BLB miteinander verbunden. Wird eine zu lesende Speicherzelle Z über eine nicht in der Fig. 1 dargestellte Wortleitung ausgewählt, fließt ein Strom $i_c$ von der Bitleitung auf derjenigen Seite in die Speicherzelle Z hinein, an der beispielsweise ein logischer Zustand "0" gespeichert ist. Auf der gegenüberliegenden Seite der Speicherzelle Z, an der ein komplementäres Signal anliegt, fließt wegen des schwachen p-Kanal-Transistors bei der klassischen 6-Transistor-Speicherzelle in der Regel kein nutzbarer Strom.

Wegen der kapazitiven und ohmschen Beläge der Wortleitungen und der Bitleitungen BL und BLB können die Speicherzellenblöcke bei gegebener Zugriffszeit nicht beliebig viele Speicherzellen Z enthalten. Je kleiner die Speicherzellenblöcke gehalten werden, desto kürzere Zugriffszeiten erzielt man. Da jedoch jeder Zellenblock Peripherieschaltungen, Decodierschaltungen, Wortleitungstreiber und Auswerteschaltungen benötigt, wird dadurch die Chipfläche größer und das Verhältnis von Fläche, die die periphere Logik einnimmt, zur Fläche der Zellenfelder ungünstiger. Wegen der hohen Anzahl von Speicherzellen Z, die mit den Bitleitungen BL und BLB verbunden sind, weisen diese Bitleitungen BL und BLB einen hohen Kapazitätsbelag $C_{BL}$ auf. Um nicht für jede Speicherzellenspalte eine Bewerterstufe mit anschließender Treiberstufe auslegen zu müssen, verwendet man einen Bitleitungsmultiplexer, der durch entsprechende Signale zur Spaltenauswahl gesteuert wird. Beim Auslesen des Speicherzustandes der Speicherzelle Z wird die Kapazität $C_{BL}$ durch den Speicherzellenstrom $i_c$ entladen. Der dabei entstehende Spannungshub $\Delta V_{BL}$ wird von einem nachgeschalteten Leseverstärker LV bewertet und als logisches Signal "0" oder "1" ausgegeben. Der Spannungshub $\Delta V_{BL}$ entspricht der Spannungsdifferenz zwischen den Bitleitungen BL und BLB. Die Zugriffszeit und die Toleranzunempfindlichkeit des Speicherzellenfeldes Z wird wesentlich von der Bewerterschaltung zum Auslesen und Bewerten des Speicherzustandes der Speicherzelle Z bestimmt. Da die SRAM-Speicherzelle auch während eines Lesevorgangs die gespeicherte Information behält, kann als Bewerterschaltung beispielsweise ein Leseverstärker LV gemäß Fig. 2 verwendet werden. Der bekannte Leseverstärker LV ist ein sogenannter Latch-Typ Leseverstärker, der als wesentliches Element zwei kreuzgekoppelte Inverter enthält, die durch Mitkopplung eine schnelle Arbeitsweise erlauben. Ein erster Schaltungsteil dieses Leseverstärkers LV weist neben diesen kreuzgekoppelten Invertern zwei p-Kanal-Transistoren M1 und M6 auf, die mit den p-Kanal-Transistoren M2 bzw. M5 parallel verschaltet sind. Der erste Schaltungsteil ist mit zwei Ausgängen SO und SON des Leseverstärkers LV verbunden. Des Weiteren sind die Transistoren M1 und M6 mit ihren Gate-Anschlüssen mit einem Eingang SAEN an dem das Signal zum Aktivieren eines Bewertungsvorgangs des Leseverstärkers LV angelegt wird, elektrisch verbunden. Ein zweiter Schaltungsteil des Leseverstärkers LV weist die n-Kanal-Transistoren M4 und M8 auf, wobei der Gate-Anschluss des Transistors M4 mit einem ersten Eingang des Leseverstärkers LV und der Gate-Anschluss des Transistors M8 mit einem zweiten Eingang des Leseverstärkers LV elektrisch verbunden ist. Des Weiteren weist der Leseverstärker LV einen n-Kanal-Transistor M9 auf, der mit den beiden Transistoren M4 und M8 einerseits und andererseits mit Massepotenzial verbunden ist. Mit seinem Gate-Anschluss ist dieser Transistor M9 mit dem Eingang SAEN verbunden. Erst bei genügend großer Spannungsdifferenz zwischen den Eingängen INN und INP wird der Leseverstärker LV über das am Eingang SAEN anliegende Signal aktiviert.

Damit der Leseverstärker LV auch bei herstellungsbedingten Unsymmetrien (Mismatch) eine korrekte Bewertung durchführt, darf der Spannungshub $\Delta V_{BL}$ nicht zu gering sein (typisch ist $\Delta V_{BL} > 100mV$). Als Leseverstärker LV kann beispielsweise auch ein Differenzverstärker mit Stromspiegellast, wie aus US 4,697,112 bekannt ist, verwendet werden.

Eine differentielle Leseverstärkerschaltung ist aus der Patentschrift DE 41 05 268 C2 bekannt. Die differentielle Leseverstärkerschaltung weist zwei Eingangsinverter mit zumindest jeweils zwei in Reihe geschaltete komplementäre Transistoren auf, wobei die Ausgänge der Inverter an ein Datenleitungspaar zur Ausgabe der verstärkten Spannungsdifferenz welche an den Eingänge detektiert wird, angeschlossen sind. Die Leseverstärkerschaltung weist einen aus komplementären Transistoren bestehenden Verriegelungsschaltkreis auf, der derart zwischen dem Datenleitungspaar geschaltet ist, dass er die Spannungsdifferenz der Ausgangsanschlüsse der beiden Eingangsinverter verstärkt. Die Eingangsanschlüsse der Eingangsinverter sind mit den Gate-Anschlüssen nur jeweils eines Transistors der in Reihe geschalteten komplementären Transistoren verbunden. Die Ausgangsanschlüsse der Eingangsinverter sind jeweils mit den Gate-Anschlüssen der anderen in Reihe geschalteten komplementären Transistoren verbunden.

Bei den bekannten Ausführungen der Schaltungsanordnung ist die Zeitdauer für das Auslesen und Bewerten des Speicherzustandes der SRAM-Speicherzelle relativ groß, da die Umladung der Bitleitungskapazität $C_{BL}$ relativ langsam vor sich geht. In modernen Halbleiter-Technologien wirkt sich darüber hinaus der ohmsche Widerstand und die Induktivität der Bitleitungen zunehmend nachteilig auf die Lesegeschwindigkeit aus. Daher ist die Schaltungsanordnung beim Auslesen insbesondere von großen Speicherzellenanordnungen (Bitleitungskapazität $C_{BL}$ relativ hoch) und geringen Versorgungsspannungen $V_{DD}$ (Speicherzellenstrom $i_C$ relativ klein) langsam.

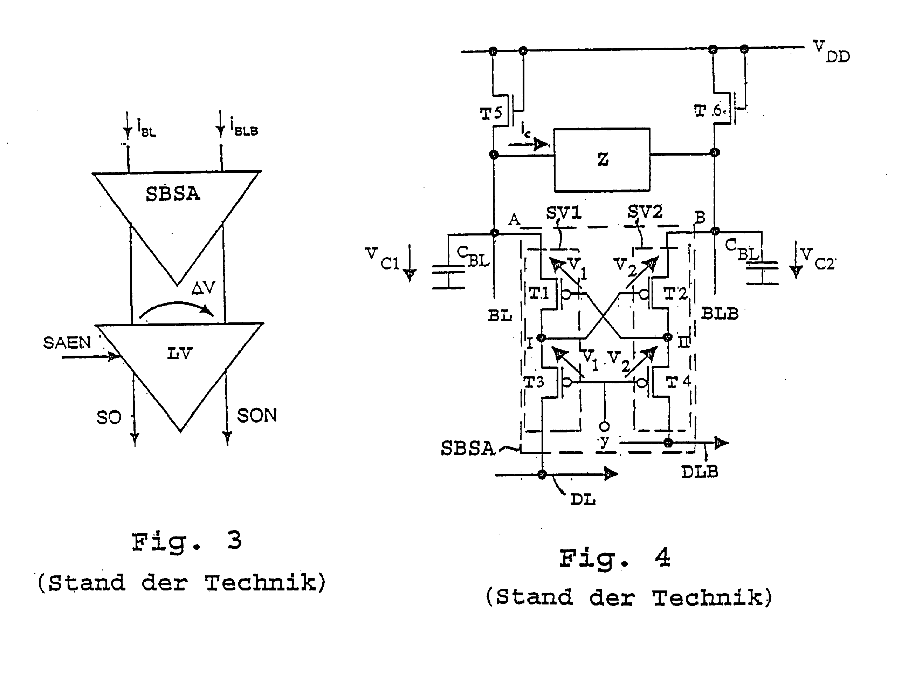

Eine Verbesserung des Auslese- und Bewertungsvorganges eines Speicherzustandes in einer SRAM-Speicherzelle kann dadurch erreicht werden, dass nicht die Spannungsdifferenz, sondern direkt die Ströme, die über die Transistoren der Speicherzelle Z fließen, bewertet werden. Dadurch kann die Umladung der Bitleitungen BL und BLB vermieden werden. Ein derartiges Konzept ist in Fig. 3 dargestellt. Dem bekannten Leseverstärker LV ist eine Strombewerterschaltung SBSA vorgeschaltet. Die Ströme $i_{BL}$ und $i_{BLB}$, die durch die Bitleitungen BL und BLB fließen, liegen an zwei Eingängen der Strombewerterschaltung SBSA an. Eine aus Klar, H.: "Integrierte Digitale Schaltungen MOS/ BICMOS", 2. Aufl., Springer-Verlag Berlin 1996, bekannte Ausführung einer derartigen Strombewerterschaltung SBSA ist in Fig. 4 gezeigt. Die Strombewerterschaltung SBSA ist aus zwei Stromverstärkern SV1 und SV2, wobei der erste Stromverstärker SV1 die p-Kanal-Transistoren T1 und T3 aufweist und der zweite Stromverstärker SV2 die p-Kanal-Transistoren T2 und T4 aufweist, aufgebaut. Die Diode-Connected-Transistoren T3 und T4 sind mit Datenleitungen DL bzw. DLB verbunden, die mittels weiterer nicht dargestellter Schaltungen auf einem Potenzial von etwa einer Einsatzspannung über Masse gehalten werden. Mittels dieser Strombewerterschaltung SBSA soll erreicht werden, dass während eines Lesevorgangs die Potenziale $V_{C1}$ und $V_{C2}$ der beiden Bitleitungen BL und BLB identisch und konstant gehalten werden und der Strom $i_C$, der in die ausgewählte Speicherzelle Z fließt, gemessen werden kann. In einer Precharge-Phase liegt der Anschluss y an einem Versorgungsspannungspotential $V_{DD}$, wodurch die Transistoren T3 und T4 sperren. Die beiden Bitleitungen BL und BLB werden auf ein Potential von $V_{DD}-V_T$ geladen. Die Spannung $V_T$ ist die Einsatzspannung der Transistoren T3 und T4.

Die Strombewerterschaltung SBSA wird aktiviert, indem das Signal y an Massepotenzial gelegt wird. In diesem Zustand ist die Speicherzelle Z noch nicht ausgewählt. Die Transistoren T1 bis T4 befinden sich im Sättigungsbereich und leiten Strom, der von den Precharge-Transistoren T5 und T6 geliefert wird. Werden die Transistoren T1 bis T4 der Strombewerterschaltung SBSA hoch-ohmig und die Precharge-Transistoren T5 und T6 nieder-ohmig dimensioniert, ist die Potenzialänderung der Bitleitungen BL und BLB relativ gering. Wird nun die Speicherzelle Z mittels einer nicht dargestellten Wortleitung ausgewählt, fließt aufgrund der gespeicherten Information ein Strom $i_C$, wie er beispielsweise in Fig. 4 eingezeichnet ist, in die Speicherzelle Z. Dies bewirkt, dass in den beiden Stromverstärkern SV1 und SV2 bzw. in den beiden Schaltungszweigen der Strombewerterschaltung SBSA unterschiedliche Ströme fließen. Da nur relativ geringe Potenzialänderungen in der Strombewerterschaltung SBSA auftreten, verbleiben die Transistoren T1 bis T4 im Sättigungsbereich. Aufgrund der Serienschaltung weisen die Transistoren T1 und T3 des ersten Stromverstärkers SV1 gleiche Gate-Source-Spannungen $V_1$ auf. Entsprechendes gilt für die Transistoren T2 und T4 des zweiten Stromverstärkers SV2, wobei diese beiden Transistoren Gate-Source-Spannungen $V_2$ aufweisen. Da der Steueranschluss y an Massepotenzial liegt und die Transistoren T1 und T2 kreuzgekoppelt sind, gelten folgende Gleichungen für die Spannungen $V_{C1}$ und $V_{C2}$ der beiden Bitleitungen BL und BLB:

$$V_{C1} = V_2 + V_1$$

$$V_{C2} = V_1 + V_2$$

Unabhängig von der Stromverteilung in der Strombewerterschaltung SBSA sind die Bitleitungspotentiale $V_{C1}$ and $V_{C2}$ identisch. Es bildet sich ein sogenannter virtueller Kurzschluss zwischen den Knoten A und B aus, wodurch die Drain-Ströme der Transistoren T5 und T6 ebenfalls gleich groß sind. Da die Speicherzelle Z Strom zieht, fließt in den Transistoren T2 und T4 ein größerer Strom als in den Transistoren T1 und T3. Die Differenz der Drain-Ströme von T3 und T4 ist identisch dem Strom $i_C$ der in die Speicherzelle Z fließt. Trotz der unterschiedlichen Ströme in den beiden Zweigen der Strombewerterschaltung SBSA sind die Spannungen $V_{C1}$ und $V_{C2}$ gleich groß und während des Lesevorgangs konstant. Bewirkt wird dies durch einen Rückkoppelmechanismus. Zunächst verringert sich dabei mit der Aktivierung der Speicherzelle Z der Strom in den Transistoren T1 und T3, während der Strom in dem zweiten Stromverstärker SV2 unverändert ist. Die Summe der Gate-Source-Spannungen $V_1 + V_2$ verringert sich. Aufgrund des erwähnten virtuellen Kurzschlusses würde dies das Potenzial des Knotenpunktes B verkleinern. Die Folge ist, dass der Precharge-Transistor T6 einen größeren Strom leitet, der eine größere Gate-Source-Spannung $V_2$ bewirkt und somit der Ursache, der Verringerung der Summe von $V_1 + V_2$, entgegenwirkt. Die Bitleitungspotenziale $V_{C1}$ und $V_{C2}$ sind während des Lesevorgangs gleich groß und konstant. Die Bitleitungskapazitäten $C_{BL}$ müssen nicht umgeladen werden. Eine derartige Schaltung ist auch aus US 5,253,137 bekannt.

Eine Möglichkeit, die Ausgangssignale der Strombewerterschaltung SBSA weiterzuverarbeiten beruht darauf, die Drain-Anschlüsse der Transistoren T3 und T4 an Massepotenzial zu legen und die Potentiale der Knotenpunkte I und II zu den Eingängen einer nachgeschalteten Leseverstärkerschaltung LV zu führen.

Derartige Ausführungen sind aus Nobutaro Shibata: "Current Sense Amplifiers for Low-Voltage Memories", IEICE Trans. E-lectron., vol. E79-C, no. 8, pp. 1120-1130, August 1996, bekannt. Die entsprechend der Strombewerterschaltung SBSA in Fig. 4 aufgebaute Strombewerterschaltung weist anstelle der Transistoren T3 und T4 Widerstände R1 und R2 auf. In einem ersten Ausführungsbeispiel ist der nachgeschaltete Leseverstärker als Stromspiegeltyp und somit als statische Differenzstufe ausgebildet. In einem zweiten Ausführungsbeispiel ist der nachgeschaltete Leseverstärker lediglich aus einfachen Invertern aufgebaut. Nachteilig bei den bekannten Strombewerterschaltungen, insbesondere bei den Ausführungen mit zwei einfachen Stromverstärkern, und den bekannten Leseverstärkern ist der relativ hohe Leistungsverbrauch sowie der realtiv große Flächenbedarf. Des Weiteren ist die Zeitdauer für das Auslesen und Bewerten eines gespeicherten Zustands in einer Speicherzelle relativ groß und die Robustheit der bekannten Schaltungsanordnungen gegenüber Herstellungstoleranzen (Mismatch, etc.) relativ gering.

Aufgabe der Erfindung ist es, eine verbesserte Schaltungsanordnung zum Auslesen und Bewerten eines Speicherzustands in einer Halbleiterspeicherzelle, insbesondere einer SRAM-Speicherzelle, zu schaffen.

Insbesondere ist es Aufgabe, eine Strombewerterschaltung zu schaffen, die ein schnelleres Auslesen und Bewerten einer zwischen zwei Leitungen auftretenden Signaldifferenz, insbesondere bei einem Lesevorgang eines Speicherzustands in einer Halbleiterspeicherzelle, welche an Signalleitungen angeschlossen ist, ermöglicht sowie einen verminderten Flächenbedarf aufweist.

Des Weiteren ist es Aufgabe der Erfindung eine Leseverstärkerschaltung zu schaffen, mit der eine Spannungsdifferenz zwischen zwei Signalleitungen, welche insbesondere durch einen Lesevorgang zum Auslesen einer gespeicherten Information einer an die Signalleitungen angeschlossenen Speicherzelle erzeugt wird, einfach bewertet werden kann und mit dem die gelesene Information unabhängig vom Zustand vorgeschalteter Schaltungsteile am Ausgang des Leseverstärkers bereitgestellt werden kann.

Weiterhin ist es Aufgabe eine Schaltungsanordnung aus einer Halbleiterspeicherzelle, insbesondere einer SRAM-Speicherzelle, einer Strombewerterschaltung und einem Leseverstärker zu schaffen, welche einen relativ geringen Leistungsverbrauch und eine schnelle und verbesserte Signalverarbeitung aufweist.

In einem ersten Aspekt der Erfindung wird die Aufgabe durch eine Strombewerterschaltung gelöst, die differentiell ausgeführt ist. Die Strombewerterschaltung weist einen Differenzverstärker mit einem ersten Eingang, der einen ersten Eingang der differentiellen Strombewerterschaltung bildet, auf. Dieser erste Eingang des Differenzverstärkers ist mit einer ersten Signalleitung eines Datenleitungspaares elektrisch verbunden. Der Differenzverstärker weist einen zweiten Eingang auf, welcher ein zweiter Eingang der differentiellen Strombewerterschaltung ist, wobei dieser zweite Eingang mit einer zweiten Signalleitung des Datenleitungspaares elektrisch verbunden ist. Zum Einstellen eines Eingangswiderstands der Strombewerterschaltung weist die differentielle Strombewerterschaltung Mittel auf, die mit Ausgängen und den Eingängen des Differenzverstärkers und mit den Signalleitungen des Datenleitungspaares elektrisch verbunden sind.

Mit der erfindungsgemäßen differentiellen Strombewerterschaltung kann ein Unterschied des in zwei Signalleitungen, insbesondere komplementären Signalleitungen, fließenden Stroms schnell ermittelt werden. Durch den relativ einfachen Aufbau kann des Weiteren eine Strombewerterschaltung geschaffen werden, die insbesondere gegenüber der Verwendung von zwei separaten Strombewerterschaltungen mit nur einem Eingang einen verminderten Flächenbedarf aufweist.

In einem bevorzugten Ausführungsbeispiel sind die Mittel zum Einstellen des Eingangswiderstandes durch zwei Transistoren eines ersten Leitungstyps ausgeführt. Der erste Transistor ist mit einem ersten Ausgang und dem ersten Eingang des Differenzverstärkers und mit der ersten Signalleitung elektrisch verbunden. Der zweite Transistor ist mit einem zweiten Ausgang des Differenzverstärkers und der zweiten Signalleitung elektrisch verbunden. Vorteilhaft ist es, wenn der erste Transistor mit seinem Gate-Anschluss mit dem ersten Ausgang des Differenzverstärkers, mit einem zweiten Anschluss mit Massepotenzial und mit einem ersten Anschluss mit der ersten Signalleitung des Datenleitungspaares verbunden ist, wobei diese Verbindung vorteilhafter Weise über einen ersten Schaltungsknoten, mit dem der erste Eingang des Differenzverstärkers elektrisch verbunden ist, realisiert ist. Der zweite Transistor ist mit seinem Gate-Anschluss mit dem zweiten Ausgang des Differenzverstärkers, mit einem zweiten Anschluss mit Massepotenzial und mit einem ersten Anschluss mit der zweiten Signalleitung des Datenleitungspaares elektrisch verbunden, wobei diese Verbindung vorteilhafter Weise über einen zweiten Schaltungsknoten, mit dem der zweite Eingang des Differenzverstärkers elektrisch verbunden ist, realisiert ist.

Dadurch kann eine besonders schnelle Arbeitsweise der Strombewerterschaltung erreicht werden. Vorteilhafter Weise weist der Differenzverstärker zwei parallel geschaltete Schaltungszweige auf, wobei in jedem der beiden Schaltungszweige ein Transistor eines ersten Leitungstyps und ein Transistor eines zweiten Leitungstyps in Reihe geschaltet sind. Bevorzugt sind die beiden Schaltungszweige jeweils mit einem Ende an ein Versorgungsspannungspotenzial $V_{DD}$ und mit dem jeweils anderen Ende mit einem ersten Anschluss eines weiteren Transistors des ersten Leitungstyps elektrisch verbunden. Es kann vorgesehen sein, dass der Transistor des ersten Leitungstyps im ersten Schaltungszweig mit seinem Gate-Anschluss mit dem zweiten Eingang des Differenzverstärkers und der Transistor des ersten Leitungstyps im zweiten Schaltungszweig mit seinem Gate-Anschluss mit dem ersten Eingang des Differenzverstärkers elektrisch verbunden ist.

In vorteilhafter Weise wird die differentielle Strombewerterschaltung durch einen Schaltungsteil zum Einstellen des Arbeitspunktes des Differenzverstärkers ergänzt, wobei dieser Schaltungsteil zumindest zwei elektrische Verbindungen mit dem Differenzverstärker aufweist. Ein bevorzugtes Ausführungsbeispiel des Schaltungsteils zum Einstellen des Arbeitspunktes kennzeichnet sich dadurch, dass ein erster Transistor des zweiten Leitungstyps mit seinem Gate-Anschluss mit einem ersten und einem zweiten Schaltungszweig des Differenzverstärkers, insbesondere mit dem Gate-Anschluss eines Transistors eines zweiten Leitungstyps im ersten Schaltungszweig und dem Gate-Anschluss eines Transistors eines zweiten Leitungstyps im zweiten Schaltungszweig, elektrisch verbunden ist. Es kann vorgesehen sein, dass der Schaltungsteil zum Einstellen des Arbeitspunktes einen zweiten Transistor des zweiten Leitungstyps aufweist, dessen Gate-Anschluss mit einem dritten Eingang der Strombewerterschaltung elektrisch verbunden ist.

Ein vorteilhaftes Ausführungsbeispiel des Schaltungsteils zum Einstellen des Arbeitspunktes des Differenzverstärkers weist einen Transistor des ersten Leitungstyps auf, dessen Gate-Anschluss mit dem Gate-Anschluss eines Transistors eines ersten Leitungstyps des Differenzverstärkers elektrisch verbunden ist, wobei dieser Transistor des Differenzverstärkers in Reihe zu den Schaltungszweigen des Differenzverstärkers geschaltet ist.

Weitere vorteilhafte Ausgestaltungen des Schaltungsteils zum Einstellen des Arbeitspunktes des Differenzverstärkers in der differentiellen Strombewerterschaltung sind in den Unteransprüchen angegeben.

Eine besonders bevorzugte Ausführungsform der differentiellen Strombewerterschaltung kennzeichnet sich durch einen Schaltungsteil zum Deaktivieren des Differenzverstärkers. Dieser Schaltungsteil weist zumindest elektrische Verbindungen zu den Ausgängen des Differenzverstärkers und zu einem dritten und einem vierten Eingang der Strombewerterschaltung auf. Vorteilhaft ist es, wenn der Schaltungsteil zusätzlich elektrische Verbindungen zu einem ersten und einem zweiten Schaltungszweig des Differenzverstärkers aufweist. Durch den Schaltungsteil zum Deaktivieren des Differenzverstärkers weist die differentielle Strombewerterschaltung einen relativ geringen Leistungsverbrauch auf. Insbesondere wenn die differentielle Strombewerterschaltung zum Auslesen eines Speicherzustands in einer Halbleiterspeicherzelle, insbesondere einer SRAM-Speicherzelle verwendet wird, kann dadurch der Differenzverstärker bzw. die gesamte differentielle Strombewerterschaltung unmittelbar nach Beendigung eines Lesevorgangs abgeschaltet werden und der Leistungsverbrauch dadurch erheblich reduziert werden.

Ein bevorzugtes Ausführungsbeispiel des Schaltungsteils zum Deaktivieren des Differenzverstärkers weist einen ersten Transistor des ersten Leitungstyps auf, welcher mit dem ersten Ausgang des Differenzverstärkers und mit dem dritten Eingang der Strombewerterschaltung verbunden ist. Zumindest ein zweiter Transistor des ersten Leitungstyps ist mit dem zweiten Ausgang des Differenzverstärkers und mit dem dritten Eingang der Strombewerterschaltung verbunden. Darüber hinaus weist der Schaltungsteil zum Deaktivieren zwei Transistoren des zweiten Leitungstyps auf, wobei der eine mit seinem Gate-Anschluss mit dem dritten Eingang der Strombewerterschaltung und der andere mit dem vierten Eigang der Strombewerterschaltung elektrisch verbunden ist. Es kann vorgesehen sein die beiden Transistoren des ersten Leitungstyps mit ihren Gate-Anschlüssen mit dem dritten Eingang der Strombewerterschaltung und mit jeweils den ersten Anschlüssen mit Massepotenzial zu verbinden. Der erste Transistor des ersten Leitungstyps ist darüber hinaus mit einem zweiten Anschluss mit dem ersten Ausgang des Differenzverstärkers und der zweite Transistor des ersten Leitungstyps mit einem zweiten Anschluss mit dem zweiten Ausgang des Differenzverstärkers elektrisch verbunden.

Vorteilhafter Weise ist der zweite Transistor des zweiten Leitungstyps des Schaltungsteils zum Deaktivieren des Differenzverstärkers mit seinem Gate-Anschluss mit dem vierten Eingang der Strombewerterschaltung, mit einem ersten Anschluss an das Versorgungsspannungspotenzial und mit einem zweiten Anschluss mit den beiden Schaltungszweigen elektrisch verbunden. Insbesondere ist dieser zweite Transistor des zweiten Leitungstyps mit Gate-Anschlüssen von Transistoren eines zweiten Leitungstyps, von denen jeweils einer in einem der Schaltungszweige des Differenzverstärkers angeordnet ist, elektrisch verbunden.

In besonders vorteilhafter Weise sind die Schaltungsteile zum Einstellen des Arbeitspunkts und zum Deaktivieren des Differenzverstärkers derart verschaltet, dass sie zumindest ein gemeinsames Bauelement aufweisen, welches beiden Schaltungsteilen zugeordnet ist. Insbesondere ist dieses Bauelement in dem Schaltungsteil zum Einstellen des Arbeitspunktes durch den zweiten Transistor des zweiten Leitungstyps bzw. im Schaltungsteil zum Deaktivieren des Differenzverstärkers durch den ersten Transistor des zweiten Leitungstyps charakterisiert. Durch die Zuordnung eines oder mehrerer Bauelemente zu den beiden Schaltungsteilen, kann die zum Ausführen dieser Funktionen - Einstellen des Arbeitspunktes und Deaktivieren des Differenzverstärkers bzw. der differentiellen Strombewerterschaltung - benötigte Anzahl an Bauelementen vermindert werden. Dadurch kann die differentielle Strombewerterschaltung mit einem reduzierten Schaltungsaufwand und darüber hinaus mit verminderten Flächenbedarf realisiert werden.

In bevorzugter Weise kann die differentielle Strombewerterschaltung durch einen weiteren Schaltungsteil, welcher zum Aktivieren des Differenzverstärkers bzw. der gesamten differentiellen Strombewerterschaltung dient, ergänzt werden. Dieser Schaltungsteil zum Aktivieren ist mit den beiden Ausgängen des Differenzverstärkers und mit einem fünften und einem sechsten Eingang der Strombewerterschaltung elektrisch verbunden. Es kann vorgesehen sein, dass dieser Schaltungsteil zum Aktivieren des Differenzverstärkers zumindest zwei Transistoren eines ersten Leitungstyps und vorteilhafterweise zumindest zwei Transistoren eines zweiten Leitungstyps aufweist. Eine vorteilhafte Schaltungsanordnung dieser vier Transistoren in dem Schaltungsteil zum Aktivieren der differentiellen Strombewerterschaltung ist in den Unteransprüchen angegeben.

Ein weiterer Aspekt der Erfindung betrachtet eine Leseverstärkerschaltung, insbesondere eine Leseverstärkerschaltung zum Bewerten einer Spannungsdifferenz zwischen zwei Datenleitungen, insbesondere komplementären Datenleitungen, an denen eine Halbleiterspeicherzelle, insbesondere eine SRAM-Speicherzelle angeschlossen ist. Die Leseverstärkerschaltung weist einen ersten Schaltungsteil auf, der entsprechend dem ersten Schaltungsteil der aus dem Stand der Technik in Fig. 2 dargestellten Leseverstärkerschaltung entspricht. Die erfindungsgemäße Leseverstärkerschaltung weist zusätzlich einen zweiten Schaltungsteil auf, der durch zwei Schaltungszweige mit jeweils zwei Transistoren gekennzeichnet ist. Die beiden Transistoren in den beiden Schaltungszweigen sind jeweils parallel geschaltet. Bevorzugt sind alle vier Transistoren der beiden Schaltungszweige von einem ersten Leitungstyp. Es kann vorgesehen sein, dass der erste Transistor im ersten Schaltungszweig mit seinem Gate-Anschluss mit einem ersten Eingang der Leseverstärkerschaltung und der zweite Transistor des ersten Schaltungszweigs mit seinem Gate-Anschluss mit einem dritten Eingang der Leseverstärkerschaltung elektrisch verbunden ist. Der erste Transistor des zweiten Schaltungszweigs ist mit seinem Gate-Anschluss mit einem vierten Eingang der Leseverstärkerschaltung und der zweite Transistor des zweiten Schaltungszweigs ist mit seinem Gate-Anschluss mit dem dritten Eingang der Leseverstärkerschaltung elektrisch verbunden. Die beiden Schaltungszweige sind mit einem Transistor des ersten Leitungstyps, welcher im zweiten Schaltungsteil des Leseverstärkers angeordnet ist, und mit welcher seinem Gate-Anschluss an dem dritten Eingang des Leseverstärkers anliegt, elektrisch verbunden. Des Weiteren weisen die beiden Schaltungszweige des zweiten Schaltungsteils zwei elektrische Verbindungen zum ersten Schaltungsteil des Leseverstärkers auf.

Durch die erfindungsgemäße Leseverstärkerschaltung kann eine aus einer der Leseverstärkerschaltung vorgeschalteten Schaltungsanordnung gelesene Information dauerhaft am Ausgang der Leseverstärkerschaltung zur Verfügung gestellt werden. Dies kann unabhängig davon gewährleistet werden in welchem Betriebszustand bzw. Schaltungszustand sich die der Leseverstärkerschaltung vorgeschalteten Schaltungsanordnung befinden. Insbesondere ist dies dann möglich, wenn eine der Leseverstärkerschaltung vorgeschaltete Strombewerterschaltung deaktiviert ist.

Des Weiteren betrachtet die Erfindung eine Schaltungsanordnung zum Auslesen und Bewerten eines Speicherzustands einer Halbleiterspeicherzelle, insbesondere einer SRAM-Speicherzelle, wobei die Halbleiterspeicherzelle mit einem Anschluss an einer ersten Datenleitung eines Datenleitungspaares und mit einem zweiten Anschluss mit einer zweiten Datenleitung des Datenleitungspaares elektrisch verbunden ist. Die Schaltungsanordnung weist eine erfindungsgemäße differentielle Strombewerterschaltung auf. Des Weiteren weist die Schaltungsanordnung eine Leseverstärkerschaltung, die der differentiellen Strombewerterschaltung nachgeschaltet ist, auf. Es kann vorgesehen sein, als Leseverstärkerschaltung eine erfindungsgemäße Leseverstärkerschaltung in der Schaltungsanordnung zu verschalten. Es kann beispielsweise aber auch eine Leseverstärkerschaltung bzw. ein Leseverstärker verwendet werden, wie sie beispielsweise aus Fig. 2 bekannt ist.

Des Weiteren betrachtet die Erfindung eine Schaltungsanordnung zum Auslesen und Bewerten eines Speicherzustands einer Halbleiterspeicherzelle, insbesondere einer SRAM-Speicherzelle, wobei die Halbleiterspeicherzelle mit einem Anschluss mit einer ersten Datenleitung eines Datenleitungspaares und mit einem zweiten Anschluss mit einer zweiten Datenleitung des Datenleitungspaares elektrisch verbunden ist, wobei die Schaltungsanordnung eine Strombewerterschaltung, insbesondere mit Mitteln zum Deaktivieren der Strombewerterschaltung, insbesondere eine differentielle Strombewerterschaltung aufweist. Des Weiteren weist die Schaltungsanordnung eine erfindungsgemäße Leseverstärkerschaltung, welche der Strombewerterschaltung nachgeschaltet ist, auf. In einem vorteilhaften Ausführungsbeispiel ist die Strombewerterschaltung entsprechend der erfindungsgemäßen differentiellen Strombewerterschaltung ausgebildet.

Eine besonders bevorzugte Ausführungsform einer Schaltungsanordnung mit einer Halbleiterspeicherzelle, einer Strombewerterschaltung und einer Leseverstärkerschaltung zeichnet sich dadurch aus, dass die Schaltungsanordnung einen Schaltungsteil zum automatischen Deaktivieren der Strombewerterschaltung nach einem Lesevorgang aufweist. Dieser Schaltungsteil zum automatischen Deaktivieren der Strombewerterschaltung ist zumindest mit einem Eingang der Strombewerterschaltung und mit zumindest mit einem Ausgang der Leseverstärkerschaltung elektrisch verbunden. Bei einer Kombination einer erfindungsgemäßen differentiellen Strombewerterschaltung und einer erfindungsgemäßen Leseverstärkerschaltung ist es vorteilhaft, den Schaltungsteil zum automatischen Deaktivieren der Strombewerterschaltung mit den beiden Ausgängen und dem dritten Eingang der Leseverstärkerschaltung und mit dem dritten und vierten Eingang der Strombewerterschaltung elektrisch zu verbinden.

Vorteilhafterweise weist der dritte Schaltungsteil zum automatischen Deaktivieren der Strombewerterschaltung eine Reihenschaltung aus einem NAND-Gatter, einem Inverter und einem Flip-Flop auf. In einem bevorzugten Ausführungsbeispiel sind die Eingänge des NAND-Gatters mit den beiden Ausgängen der Leseverstärkerschaltung verbunden. Ein Ausgang des Flip-Flops ist mit dem vierten Eingang der Strombewerterschaltung und ein invertierter Ausgang des Flip-Flops ist mit dem dritten Eingang der Strombewerterschaltung und dem vierten Eingang der Leseverstärkerschaltung elektrisch verbunden. Durch den Schaltungsteil zum automatischen Deaktivieren kann eine weitere Verbesserung im Hinblick auf Leistungsverbrauch der Schaltungsanordnung und Reduzierung der Zeitdauer für das Auslesen und Bewerten eines Speicherzustands in der SRAM-Speicherzelle erreicht werden.

Ausführungsbeispiele der differentiellen Strombewerterschaltung, der Leseverstärkerschaltung und einer Schaltungsanordnung zum Auslesen und Bewerten eines Speicherzustandes in einer Halbleiterspeicherzelle werden nachfolgend anhand von schematischen Zeichnungen näher erläutert. Es zeigen:

Fig. 1 eine aus dem Stand der Technik bekannte Anordnung von Speicherzellen und einer Leseverstärkerschaltung;

Fig. 2 eine aus dem Stand der Technik bekannte Leseverstärkerschaltung;

Fig. 3 eine aus dem Stand der Technik bekannte Reihenschaltung einer Strombewerterschaltung und einer Leseverstärkerschaltung;

Fig. 4 eine aus dem Stand der Technik bekannte Ausführung einer Strombewerterschaltung;

Fig. 5 eine erste Darstellung einer erfindungsgemäßen Strombewerterschaltung;

Fig. 6 eine Darstellung eines Teilbereichs der erfindungsgemäßen Strombewerterschaltung;

Fig. 7 eine Darstellung einer erfindungsgemäßen Leseverstärkerschaltung;

Fig. 8 eine erfindungsgemäße Schaltungsanordnung zum Auslesen und Bewerten eines Speicherzustands einer Halbleiterspeicherzelle mit automatischer Deaktivierung der Strombewerterschaltung;

Fig. 9 ein Funktionsdiagramm der erfindungsgemäßen Schaltungsanordnung gemäß Fig. 8;

Fig. 10 ein zweites Ausführungsbeispiel einer erfindungsgemäßen Strombewerterschaltung mit vorgeschalteten Speicherzellen; und

Fig. 11 ein drittes Ausführungsbeispiel einer Beschaltung einer erfindungsgemäßen Strombewerterschaltung mit vorgeschalteten Speicherzellen.

In den Figuren sind gleiche oder funktionsgleiche Elemente mit den gleichen Bezugszeichen bezeichnet.

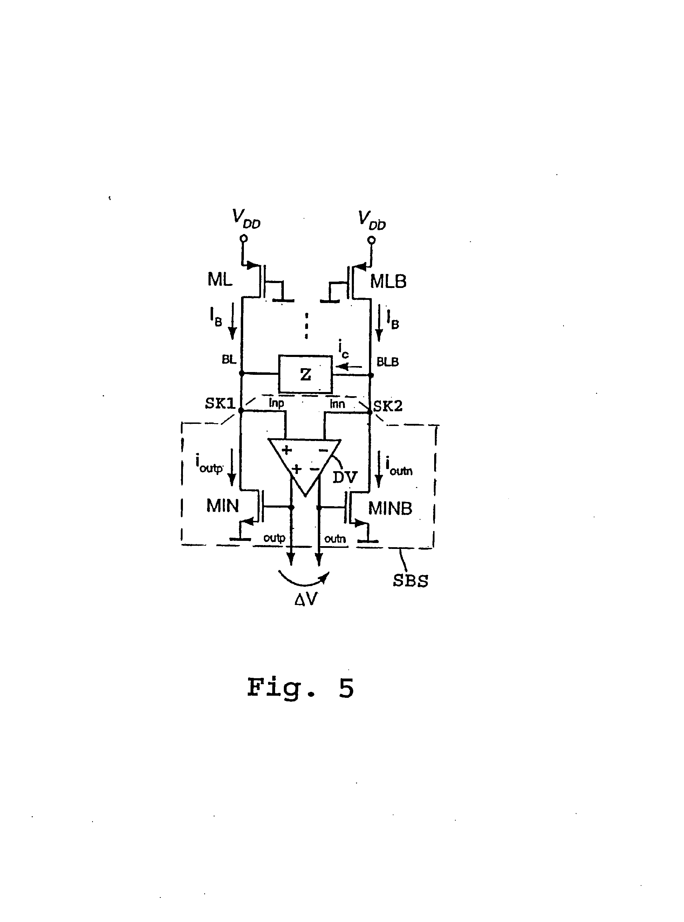

Eine erfindungsgemäße differentielle Strombewerterschaltung SBS (Fig. 5) weist einen Differenzverstärker DV auf, dessen erster Eingang inp mit einer ersten Bitleitung BL eines Bitleitungspaares elektrisch verbunden ist. Ein zweiter Eingang inn des Differenzverstärkers DV ist mit einer zweiten Bitleitung BLB des Bitleitungspaares elektrisch verbunden. Die beiden Eingänge inp und inn sind zugleich der erste bzw. der zweite Eingang der differentiellen Strombewerterschaltung SBS. Ein erster Ausgang outp des Differenzverstärkers DV, welcher ein erster Ausgang der Strombewerterschaltung SBS ist, ist mit dem Gate-Anschluss eines im Ausführungsbeispiel als n-Kanal-Transistor ausgeführten Transistors MIN verbunden. Der Transistor MIN ist mit seinem Source-Anschluss mit Massepotenzial und seinem Drain-Anschluss über einen ersten Schaltungsknoten SK1 mit der ersten Bitleitung BL und dem ersten Eingang inp des Differenzverstärkers DV elektrisch verbunden. Ein zweiter Ausgang outn des Differenzverstärkers DV, welcher ein zweiter Ausgang der differentiellen Strombewerterschaltung SBS ist, ist mit dem Gate-Anschluss eines im Ausführungsbeispiel als n-Kanal-Transistor ausgeführten Transistors MINB elektrisch verbunden. Der Transistor MINB weist mit seinem Source-Anschluss eine Verbindung zu Massepotenzial und mit seinem Drain-Anschluss über einen zweiten Schaltungsknoten SK2 eine Verbindung zur zweiten Bitleitung BLB und zum zweiten Eingang inn des Differenzverstärkers DV auf.

Eine Speicherzelle, die im Ausführungsbeispiel als SRAM-Speicherzelle ausgeführt ist, weist eine erste Verbindung mit der Bitleitung BL und eine zweite Verbindung mit der zweiten Bitleitung BLB auf. Mittels der im Ausführungsbeispiel als p-Kanal-Transistoren ausgeführten Transistoren ML und MLB wird ein Arbeitspunktstrom $I_B$ an den Bitleitungen BL und BLB eingestellt. Dieser Arbeitspunktstrom $I_B$ fließt durch die Eingangstransistoren MIN und MINB der differentiellen Strombewerterschaltung SBS. Der Spannungsdifferenzverstärker DV erfasst die Spannungsdifferenz zwischen den beiden Bitleitungen BL und BLB. Bei einem Lesevorgang wird der Arbeitspunktstrom $I_B$ abhängig vom gespeicherten Zustand (logischer Zustand "0" oder logischer Zustand "1") auf einer Seite um den Speicherzellenstrom $i_C$ vermindert. Dadurch verringert sich geringfügig die Spannung an der betroffenen Bitleitung, im Ausführungsbeispiel die Spannung an der Bitleitung BLB. Dadurch verringert sich auch die Spannung am Eingang inn des Differenzverstärkers DV. Durch die Rückkoppelung der Ausgänge outp und outn des Differenzverstärkers DV über die beiden Transistoren MIN und MINB wird das Einstellen eines geringen Eingangswiderstands für eine Stromdetektion an den Eingängen der Strombewerterschaltung SBS erzeugt und die Spannungsänderung an der Bitleitung BLB gegen den Wert 0 ausgeregelt. Wird beispielsweise an der Bitleitung BLB ein logischer Zustand "0" gelesen so wirkt der Rückkoppelmechanismus wie folgt. Der Arbeitspunktstrom $I_B$ wird in der Bitleitung BLB um den Speicherzellenstrom $i_C$ vermindert wodurch die Spannung am Eingang inn des Differenzverstärkers DV sinkt. Als Folge davon sinkt die Ausgangsspannung am zweiten Ausgang outn des Differenzverstärkers DV und damit auch die Gate-Spannung des Transistors MINB. Dies bewirkt ein Absinken des Stroms $i_{outn}$. Diese Abnahme des Stroms $i_{outn}$ wirkt einer Reduzierung der Spannung in der Bitleitung BLB entgegen. Gleichzeitig steigt die Spannung am ersten Ausgang outp des Differenzverstärkers DV. Die an den Ausgängen outp und outn des Differenzverstärkers DV bzw. der differentiellen Strombewerterschaltung SBS erzeugte Spannungsdifferenz $\Delta V$ ist ein Maß für den Speicherzellenstrom $i_C$ sowie für die gespeicherte Information in der Speicherzelle Z und kann durch einen nicht dargestellten nachgeschalteten Leseverstärker bewertet werden.

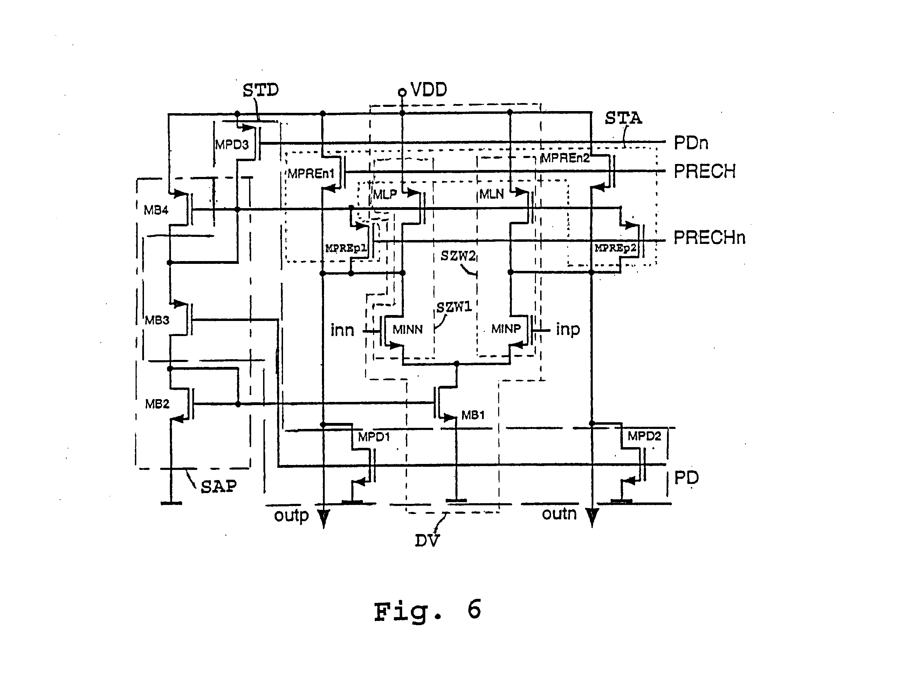

Der Differenzverstärker DV weist einen ersten Schaltungszweig SZW1 (Fig. 6) und einen zweiten Schaltungszweig SZW2 auf. Der erste Schaltungszweig SZW1 weist einen Transistor MLP, der im Ausführungsbeispiel als p-Kanal-Transistor ausgeführt ist, auf, welcher mit seinem Source-Anschluss mit Versorgungsspannungspotenzial $V_{DD}$ und mit seinem Drain-Anschluss mit dem Drain-Anschluss eines Transistors MINN, welche im Ausführungsbeispiel als n-Kanal-Transistor ausgeführt ist, auf. Der Transistor MINN ist mit seinem Gate-Anschluss mit dem zweiten Eingang inn des Differenzverstärkers DV elektrisch verbunden. Des Weiteren sind die Drain-Anschlüsse der Transistoren MLP und MINN mit dem ersten Ausgang outp des Differenzverstärkers DV elektrisch verbunden. Der zweite Schaltungszweig SZW2 weist einen p-Kanal-Transistor MLN und einen n-Kanal-Transistor MINP auf. Die Drain-Anschlüsse der Transistoren MLN und MINP sind mit dem zweiten Ausgang outn des Differenzverstärkers DV verbunden. Der Transistor MINP ist über seinen Gate-Anschluss mit dem ersten Eingang inp des Differenzverstärkers DV elektrisch verbunden. Der zweite Schaltungzweig SZW2 ist über den Source-Anschluss des Transistors MLN mit dem Versorgungsspannungspotenzial $V_{DD}$ verbunden. Beide Schaltungszweige SZW1 und SZW2 sind über die Source-Anschlüsse der Transistoren MINN und MINP mit dem Drain-Anschluss des nachgeschalteten n-Kanal-Transistors MB1 elektrisch verbunden.

In vorteilhafter Weise ist der Differenzverstärker DV durch einen Schaltungsteil SAP zum Einstellen des Arbeitspunktes des Differenzverstärkers DV, durch einen Schaltungsteil STD zum Deaktivieren des Differenzverstärkers DV bzw. der gesamten differentiellen Strombewerterschaltung SBS (Fig. 5) sowie durch einen Schaltungsteil STA zum Aktivieren des Differenzverstärkers DV bzw. der differentiellen Strombewerterschaltung SBS, erweitert. Der Schaltungsteil SAP zum Einstellen des Arbeitspunktes weist im Ausführungsbeispiel einen n-Kanal-Transistor MB2 und zwei p-Kanal-Transistoren MB3 und MB4 auf. Der Source-Anschluss des Transistors MB2 ist mit Massepotential verbunden. Der Gate-Anschluss des Transistors MB2 ist mit dem Gate-Anschluss des Transistors MB1 des Differenzverstärkers DV elektrisch verbunden. Der Drain-Anschluss des Transistors MB2 ist mit dem Gate-Anschluss des Transistors MB2 rückgekoppelt und mit dem Drain-Anschluss des Transistors MB3 elektrisch verbunden. Der Gate-Anschluss des Transistors MB3 ist mit einem dritten Eingang PD der differentiellen Strombewerterschaltung SBS (Fig. 5) elektrisch verbunden. Der Transistor MB4 ist mit seinem Source-Anschluss mit dem Versorgungsspannungspotenzial $V_{DD}$ verbunden. Der Drain-Anschluss des Transistors MB4 ist mit dem eigenen Gate-Anschluss und mit dem Source-Anschluss des Transistors MB3 elektrisch verbunden. Der Gate-Anschluss des Transistors MB4 ist des Weiteren mit den Gate-Anschlüssen der Transistoren MLP und MLN des Differenzverstärkers DV elektrisch verbunden.

Der Schaltungsteil SAP zum Einstellen des Arbeitspunktes des Differenzverstärkers DV weist über die Gate-Anschlüsse der Transistoren MB2 und MB4 zwei elektrische Verbindungen zu dem Differenzverstärker DV auf.

Der Schaltungsteil STD zum Deaktivieren der differentiellen Strombewerterschaltung SBS umfasst die beiden im Ausführungsbeispiel als n-Kanal-Transistoren ausgeführten Transistoren MPD1 und MPD2. Des Weiteren weist der Schaltungsteil STD den p-Kanal-Transistor MPD3 auf. Als vierten Transistor weist der Schaltungsteil STD den auch zum Schaltungsteil SAP gehörenden Transistor MB3 auf. Die Transistoren MPD1 und MPD2 sind jeweils mit ihren Gate-Anschlüssen mit dem dritten Eingang PD der differentiellen Strombewerterschaltung SBS und jeweils mit ihren Source-Anschlüssen mit Massepotenzial elektrisch verbunden. Der Transistor MPD1 ist mit seinem Drain-Anschluss mit dem ersten Ausgang outp des Differenzverstärkers DV und der Transistor MPD2 ist mit seinem Drain-Anschluss mit dem zweiten Ausgang outn des Differenzverstärkers DV verbunden. Der Transistor MPD3 ist mit seinem Source-Anschluss mit Versorgungsspannungspotenzial $V_{DD}$ und mit seinem Gate-Anschluss mit einem vierten Eingang PDn der differentiellen Strombewerterschaltung SBS verbunden. Der Drain-Anschluss des Transistors MPD3 ist mit dem Source-Anschluss des Transistors MB3, mit dem Gate-Anschluss des Transistors MB4 und mit den Gate-Anschlüssen der Transistoren MLP und MLN elektrisch verbunden. Der Schaltungsteil STD zum Deaktivieren der differentiellen Strombewerterschaltung SBS weist somit eine elektrische Verbindung zum ersten und zum zweiten Schaltungszweig SZW1 und SZW2 und den Ausgängen outp und outn des Differenzverstärkers DV sowie zu dem dritten und vierten Eingang PD und PDn der Strombewerterschaltung SBS auf.

Der Schaltungsteil STA zum Aktivieren der differentiellen Strombewerterschaltung SBS weist im Ausführungsbeispiel vier Transistoren auf, von denen zwei Transistoren MPREn1 und MPREn2 als n-Kanal-Transistoren ausgeführt sind. Die beiden weiteren Transistoren MPREp1 und MPREp2 sind als p-Kanal-Transistoren ausgebildet. Die Transistoren MPREp1 und MPREp2 sind mit ihren Source-Anschlüssen mit dem Gate-Anschluss des Transistors MB4 und den Gate-Anschlüssen der Transistoren MLP und MLN verbunden. Mit ihren Gate-Anschlüssen sind diese beiden Transistoren MPREp1 und MPREp2 mit einem fünften Eingang PRECHn der Strombewerterschaltung SBS elektrisch verbunden. Der Transistor MPREp1 ist mit seinem Drain-Anschluss mit dem ersten Ausgang outp verbunden. Der Transistor MPREp2 ist mit seinem Drain-Anschluss mit dem zweiten Ausgang outn des Differenzverstärkers DV bzw. der differentiellen Strombewerterschaltung SBS elektrisch verbunden. Die beiden Transistoren MPREn1 und MPREn2 sind jeweils mit ihren Drain-Anschlüssen an Versorgungsspannungspotential $V_{DD}$ und mit ihren Gate-Anschlüssen mit einem fünften Eingang PRECH der differentiellen Strombewerterschaltung SBS verbunden. Der Transistor MPREn1 ist mit seinem Source-Anschluss mit dem ersten Ausgang outp der differentiellen Strombewerterschaltung SBS verbunden. Der Transistor MPREn2 ist mit seinem Source-Anschluss mit dem zweiten Ausgang outn der differentiellen Strombewerterschaltung SBS elektrisch verbunden.

Die Funktionsweise des in Fig. 6 dargestellten Differenzverstärkers DV mit der entsprechenden Zusatzbeschaltung durch die Schaltungsteile SAP, STD und STA wird nachfolgend erläutert. Zum Abschalten des Differenzverstärkers DV bzw. der in Fig. 6 ohne die beiden Transistoren MIN und MINB (Fig. 5) dargestellten differentiellen Strombewerterschaltung SBS, wird am Eingang PD beispielsweise ein dem logischen Zustand "1" entsprechendes Signal und an dem Eingang PDn ein dazu invertiertes Signal angelegt. Beispielsweise kann das am Eingang PD angelegte Signal ein Betriebsspannungssignal sein. Durch das Anlegen derartiger Signale an diese Eingänge PD und PDn sperrt der Transistor MB3 und unterbricht den Stromfluss durch die Transistoren MB2 und MB4. Obwohl der Transistor MB4 durch seine Rückkoppelung sich selbst sowie die an seinem Gate-Anschluss angeschlossenen Transistoren MLP und MLN abschaltet, zieht der Transistor MPD3 zusätzlich die Gate-Spannung des Transistors MB4, des Transistors MLP und des Transistors MLN gegen die Betriebsspannung. Dadurch wird erreicht, dass diese Transistoren MB4, MLP und MLN sehr schnell sperren. Des Weiteren werden die Ausgänge outp und outn des Differenzverstärkers durch die Transistoren MPD1 und MPD2 gegen Massepotenzial gezogen, wodurch die angeschlossenen und in Fig. 6 nicht dargestellten Eingangstransistoren MIN und MINB der differentiellen Strombewerterschaltung (Fig. 5) sperren. Dadurch kann erreicht werden, dass nach dieser Abschaltung durch die Datenleitungen BL und BLB kein Strom mehr fließt, und somit keine statische Verlustleistung auftritt.

Zum Aktivieren der differentiellen Strombewerterschaltung SBS wird das Signal am Eingang PD auf den logischen Zustand "0" sowie das Signal am Eingang PDn auf den logischen Zustand "1" gesetzt. Um diesen Aktivierungsvorgang zu beschleunigen, befindet sich an dem Ausgang outp den Transistorpaar MPREp1 und MPREn1 sowie am Ausgang outn das Tranistorpaar MPREp2 und MPREn2. Diese vier Transistoren MPREn1, MPREn2, MPREp1 und MPREp2 werden nur für eine kurze Vorladephase (Precharge-Phase) eingeschaltet. In diesem Fall wird das Signal am Eingang PRECH auf einen logischen Zustand "1" und am EingangPRECHn auf den logischen Zustand "0" gesetzt.

Zunächst laden n-Kanal-Transistoren MPREn1 und MPREn2 die Ausgänge outp und outn sehr schnell auf das Potenzial $V_{DD}$- $V_T$ auf. Die langsameren p-Kanal-Transistoren MPREp1 und MPREp2 dienen des Weiteren einer Feineinstellung, indem sie die beiden Ausgänge outp und outn auf die Gate-Spannung des Tranistors MB4 laden. Dadurch kann in vorteilhafter Weise erreicht werden, dass auch bei großen Schwankungen der Vorladedauer die Ausgänge outp und outn auf einen konstanten Spannungswert geladen werden. Zudem ergeben sich durch die Verwendung von komplementären Transistoren MPREn1, MPREp1 bzw. MPREn2 und MPREp2 zum Vorladen gegenüber einer Verwendung von Einzeltransistoren während des Abschaltens dieser Transistoren wesentlich weniger Störungen der Ausgangsspannungen, da sich die von den parasitären Transistorkapazitäten in den Ausgangsknoten strömenden Ladungen weitgehend ausgleichen. Durch die zusätzlichen Schaltungsteile SAP, STD und STA kann die Eingangsstufe bzw. die differentielle Strombewerterschaltung SBS sofort nach Beendigung eines Lesevorgangs relativ rasch abgeschaltet werden und zu Beginn eines Lesevorgangs sehr schnell wieder aktiviert werden, wodurch der Leistungsverbrauch der differentiellen Strombewerterschaltung SBS erheblich reduziert werden kann.

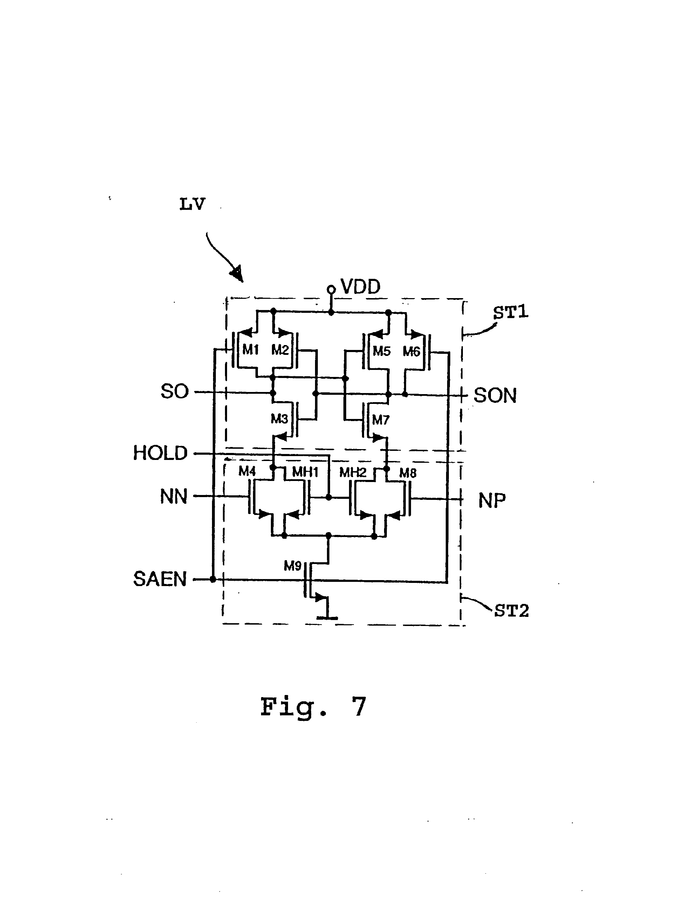

Die an den Ausgängen outp und outn der differentiellen Strombewerterschaltung SBS anliegende Spannung $\Delta V$, welche den Speicherzellenstrom $i_C$ proportional ist, kann mit einem nachgeschalteten Leseverstärker bewertet werden. Beispielsweise kann der differentiellen Strombewerterschaltung SBS eine erfindungsgemäße Leseverstärkerschaltung LV gemäß Fig. 7 nachgeschaltet sein. Die Leseverstärkerschaltung LV weist einen ersten Schaltungsteil ST1 auf, welcher in seiner Verschaltung und seinem Aufbau dem ersten Schaltungsteil der aus Fig. 2 bekannten Leseverstärkerschaltung entspricht. Ein zweiter Schaltungsteil ST2 der Leseverstärkerschaltung LV weist einen ersten Schaltungszweig welcher die Transistoren M4 und MH1 und einen zweiten Schaltungsteil in dem die Transistoren M8 und MH2 angeordnet sind, auf. Diese vier Transistoren M4, M8, MH1 und MH2 sind im Ausführungsbeispiel als n-Kanal-Transistoren ausgebildet. Die Transistoren M4 und MH1 sind im ersten Schaltungszweig parallel geschaltet, wobei der Transistor M4 mit seinem Gate-Anschluss mit einem ersten Eingang NN der Leseverstärkerschaltung LV elektrisch verbunden ist. Der Transistor MH1 ist mit seinem Gate-Anschluss mit einem weiteren Eingang HOLD verbunden. Die beiden Transistoren M4 und MH1 sind mit ihren Drain-Anschlüssen mit dem Source-Anschluss des Transistors M3 des ersten Schaltungsteils ST1 und mit ihren Source-Anschlüssen mit dem Drain-Anschluss des Transistors M9 elektrisch verbunden. Der Transistor M8 im zweiten Schaltungszweig ist mit seinem Gate-Anschluss mit einem zweiten Eingang NP der Leseverstärkerschaltung LV elektrisch verbunden. Der Transistor MH2 weist mit seinem Gate-Anschluss eine elektrische Verbindung zu dem Eingang HOLD auf. Die beiden Transistoren M8 und MH2 sind mit ihren Drain-Anschlüssen mit dem Source-Anschluss des Transistors M7 des ersten Schaltungsteils ST1 und mit ihren Source-Anschlüssen mit dem Drain-Anschluss des Transistors M9 elektrisch verbunden. Der Transistor M9 ist mit seinem Gate-Anschluss mit dem Eingang SAEN der Leseverstärkerschaltung LV verbunden und mit seinem Source-Anschluss an Massepotenzial geführt.

Liegt an den Eingängen NN und NP ein Signal an, welches beispielsweise der Spannungsdifferenz $\Delta V$ entspricht und beispielsweise durch eine der Leseverstärkerschaltung LV vorgeschaltete Strombewerterschaltung SBS erzeugt wird, wird in der Leseverstärkerschaltung eine Bewertung dieses Signals dann durchgeführt, wenn am Eingang SAEN ein Aktivierungssignal zum Starten eines Bewertungsvorgangs anliegt. An den beiden Ausgängen SO und SON der Leseverstärkerschaltung LV wird dadurch ein entsprechendes Ausgangssignal erzeugt. Wird die der Leseverstärkerschaltung LV vorgeschaltete Schaltungsanordnung, durch welche das an den Eingängen NN und NP anliegende Signal erzeugt wird, beispielsweise eine Strombewerterschaltung SBS, deaktiviert, schalten die Eingangstransistoren M4 und M8 ab. Damit die Leseverstärkerschaltung LV auch nach dieser Deaktivierung der vorgeschalteten Schaltungsanordnung an seinen Ausgängen SO und SON weiterhin die an seinen Eingängen NN und NP angelegten Information zur Verfügung stellt, werden die beiden Transistoren MH1 und MH2 durch ein Signal am Eingang HOLD aktiviert. Dadurch werden die Transistoren M4 und M8 überbrückt und die über die Eingänge NN und NP gelesene Information auch nach dem Abschalten der Transistoren M4 und M8 an den Ausgängen SO und SON zur Verfügung gestellt.

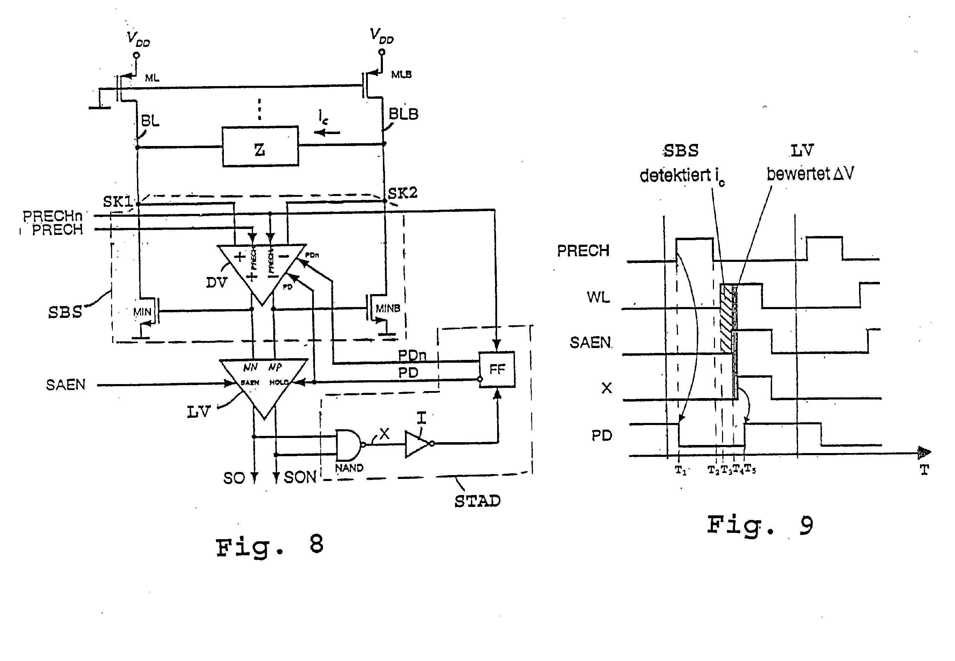

Eine erfindungsgemäße Schaltungsanordnung zum Auslesen und Bewerten eines Speicherzustands in einer Halbleiterspeicherzelle, insbesondere einer SRAM-Speicherzelle ist in Fig. 8 dargestellt. Die Schaltungsanordnung weist eine SRAM-Speicherzelle Z auf, welche mit den Bitleitungen BL und BLB verbunden ist. Die Bitleitung BL ist mit dem Schaltungsknoten SK1 und die Bitleitung BLB ist mit dem Schaltungsknoten SK2 elektrisch verbunden. Des Weiteren weist die Schaltungsanordnung eine Strombewerterschaltung SBS und einen der Strombewerterschaltung SBS nachgeschaltete Leseverstärkerschaltung LV auf. Im Ausführungsbeispiel gemäß Fig. 8 ist die Strombewerterschaltung SBS als differentielle Strombewerterschaltung SBS entsprechend der erfindungsgemäßen differentiellen Strombewerterschaltung SBS in Fig. 5 ausgeführt. Der Differenzverstärker DV ist entsprechend Fig. 6 ausgeführt. Die Leseverstärkerschaltung LV ist im Ausführungsbeispiel gemäß Fig. 8 entsprechend der erfindungsgemäßen Leseverstärkerschaltung LV in Fig. 7 ausgeführt. Des Weiteren weist die Schaltungsanordnung einen Schaltungsteil STAD zum Aktivieren und automatischen Deaktivieren der differentiellen Strombewerterschaltung SBS auf. Der Schaltungsteil STAD weist eine Reihenschaltung aus einem NAND-Gatter, einem Inverter I und einem Flip-Flop FF, welches im Ausführungsbeispiel als RS-Flip-Flop ausgebildet ist, auf. Ein erster Eingang des NAND-Gatters ist mit dem ersten Ausgang SO und ein zweiter Eingang des NAND-Gatters ist mit dem zweiten Ausgang SON der Leseverstärkerschaltung LV elektrisch verbunden. Das Ausgangssignal des Inverters I liegt an einem ersten Eingang des Flip-Flops FF an. An einem zweiten Eingang des Flip-Flops FF wird das Signal angelegt, welches über den Eingang PRECHn an dem entsprechenden Eingang der differentiellen Strombewerterschaltung SBS anliegt. Das Flip-Flop FF ist mit einem ersten Ausgang mit dem Eingang PDn der differentiellen Strombewerterschaltung SBS bzw. des Differenzverstärkers DV elektrisch verbunden. Ein zweiter, zum ersten Ausgang PDn invertierter Ausgang PD des Flip-Flops FF ist mit dem Eingang PD des Differenzverstärkers DV und mit dem Eingang HOLD der Leseverstärkerschaltung LV elektrisch verbunden.

Die Funktionsweise des Aktivierens und automatischen Deaktivierens der differentiellen Strombewerterschaltung SBS wird nachfolgend erläutert. Ein Vorladesignal wird an den Eingang PRECH der differentiellen Strombewerterschaltung SBS bzw. des Differenzverstärkers DV angelegt. Der Lesevorgang startet dann, wenn beispielsweise eine steigende Flanke des Vorladesignals detektiert wird. Ein komplementäres Vorladesignal wird an den Eingang PRECHn angelegt. Über das Flip-Flop FF wird das Signal am Ausgang PD auf den logischen Zustand "0" gesetzt und dadurch die differentielle Strombewerterschaltung SBS aktiviert. Dieser aktivierte Zustand bleibt auch nach dem folgenden Deaktivieren des Vorladesignals am Eingang PRECH (Signal entsprechend dem logischen Zustand "0") erhalten. Über eine nicht dargestellte Wortleitung wird die ausgewählte SRAM-Speicherzelle Z mit der Bitleitung BLB verbunden und der Strom $i_C$ beginnt zu fließen, wodurch in der differentiellen Strombewerterschaltung SBS ein Spannungssignal entsprechend der Spannungsdifferenz $\Delta V$ umgewandelt wird. Durch Anlegen eines Aktivierungssignals am Eingang SAEN der Leseverstärkerschaltung LV wird dieses Spannungssignal entsprechend dieser Spannungsdifferenz $\Delta V$ bewertet. Zeitlich vor dieser Aktivierung über den Eingang SAEN sind beide Ausgänge SO und SON der Leseverstärkerschaltung LV auf ein Betriebsspannungspotenzial (logischer Zustand "1") geladen. Während der Bewertungsphase in der Leseverstärkerschaltung LV wird einer der beiden Ausgänge SO oder SON auf einen logischen Zustand "0" gesetzt. Mit diesem Wechsel des logischen Zustandes ist gleichzeitig der Lesevorgang beendet. Das an den Ausgängen SO und SON angeschlossene NAND-Gatter schaltet von einem logischen Zustand "0" auf einen logischen Zustand "1". Das Ausgangssignal X wird an den nachgeschalteten Inverter I angelegt. Der Inverter I erzeugt ein entsprechendes Ausgangssignal, wodurch das Ausgangssignal des Flip-Flops FF am Ausgang PD auf den logischen Zustand "1" gesetzt wird und die differentielle Strombewerterschaltung SBS abgeschaltet wird. Es kann vorgesehen sein, dass dieser Aktivierungs- und Deaktivierungszyklus durch ein entsprechendes Signal am Eingang PRECH erneut gestartet wird. Das Signal des Ausgangs PD wird auch an den Eingang HOLD der Leseverstärkerschaltung LV angelegt. Dadurch wird auch nach der automatischen Deaktivierung der differentiellen Strombewerterschaltung SBS an den Ausgängen SO und SON der Leseverstärkerschaltung LV die gelesene Information zur Verfügung gestellt. Wie bereits in den Ausführungen zu Fig. 7 erwähnt, werden die mit den Eingängen NN und NP der Leseverstärkerschaltung LV verbundenen Transistoren M4 und M8 (Fig. 7) durch die Transistoren MH1 und MH2 (Fig. 7) überbrückt, da diese Transistoren M4 und M8 abschalten, weil die Ausgangsspannung der vorgeschalteten differentiellen Strombewerterschaltung SBS auf einen Spannungswert 0 gezogen wird, um die Transistoren MIN und MINB abzuschalten.

In dem Funktionsdiagramm gemäß Fig. 9 ist der zeitliche Verlauf der Signale dargestellt. Zum Zeitpunkt $T_1$ wird das Vorladesignal am Eingang PRECH vom logischen Zustand "0" auf den logischen Zustand "1" gesetzt und der Lesevorgang gestartet. Zeitgleich wird das Signal am Ausgang PD des Flip-Flops FF vom logischen Zustand "1" auf den logischen Zustand "0" gesetzt. Zu einem Zeitpunkt $T_2$ wird das Vorladesignal wieder auf den logischen Zustand "0" gesetzt. Zu einem Zeitpunkt $T_3$ wird das Wortleitungssignal WL von einem logischen Zustand "0" auf einen logischen Zustand "1" gesetzt und die Speicherzelle Z ausgewählt. In der Zeitdauer zwischen den Zeitpunkten $T_3$ und $T_4$ wird der Speicherzellenstrom $i_C$ durch die differentielle Strombewerterschaltung SBS detektiert. Zum Zeitpunkt $T_4$ wird das Signal am Eingang SAEN des Leseverstärkers LV von einem logischen Zustand "0" auf einen logischen Zustand "1" gesetzt. Ab diesem Zeitpunkt $T_4$ wird solange eine Bewertung der an den Eingängen NN und NP anliegenden Signale durchgeführt, bis einer der Ausgänge SO und SON einen logischen Zustand "0" annimmt. Zu diesem Zeitpunkt ist der Lesevorgang bzw. die Bewertungsphase beendet und das Ausgangssignal X des NAND-Gatters (Fig. 8) wird von einem logischen Zustand "0" auf einen logischen Zustand "1" gesetzt. Dieses Signal X wird über den Inverter I zu dem Flip-Flop FF geführt und das Signal am Ausgang PD zu einem Zeitpunkt $T_5$ vom logischen Zustand "0" auf den logischen Zustand "1" gesetzt.

Es kann auch vorgesehen sein, dass die Schaltungsanordnung zum Auslesen und Bewerten eines Speicherzustandes der SRAM-Speicherzelle eine erfindungsgemäße differentielle Strombewerterschaltung SBS gemäß Fig. 5, insbesondere mit einem Differenzverstärker DV welcher eine Zusatzbeschaltung entsprechend der Darstellung in Fig. 6 aufweist besitzt, und einen aus dem Stand der Technik bekannten Leseverstärker LV, beispielsweise einen Leseverstärker LV gemäß Fig. 2, vorgeschaltet ist. Da diese bekannte Leseverstärkerschaltung LV keinen Eingang HOLD aufweist, kann in diesem Falle die an den Eingängen gelesene Information nach der automatischen Deaktivierung der differentiellen Strombewerterschaltung SBS durch den Schaltungsteil STAD nicht weiterhin zur Verfügung gestellt werden. Möglich ist es auch, den Differenzverstärker DV in der erfindungsgemäßen differentiellen Strombewerterschaltung SBS ohne die Schaltungsteile STA, STD und SAP auszuführen. In diesem Falle kann jedoch keine automatische Deaktivierung durchgeführt werden und der Schaltungsteil STAD ist nicht notwendig.

Eine Schaltungsanordnung zum Auslesen und Bewerten eines Speicherzustandes einer SRAM-Speicherzelle kann auch derart ausgeführt sein, dass die Schaltungsanordnung eine aus dem Stand der Technik bekannte Strombewerterschaltung, beispielsweise die in Fig. 4 dargestellte Strombewerterschaltung SBS aufweist. Zum Bewerten des Ausgangssignals dieser Strombewerterschaltung kann die Schaltungsanordnung eine erfindungsgemäße Leseverstärkerschaltung LV gemäß Fig. 7 aufweisen. Ein automatisches Deaktivieren der Strombewerterschaltung SBS und damit ein Verschalten des Schaltungsteils STAD in der Schaltungsanordnung kann in diesem Falle nur dann durchgeführt werden, wenn die Strombewerterschaltung insbesondere Mittel zum Deaktivieren aufweist.

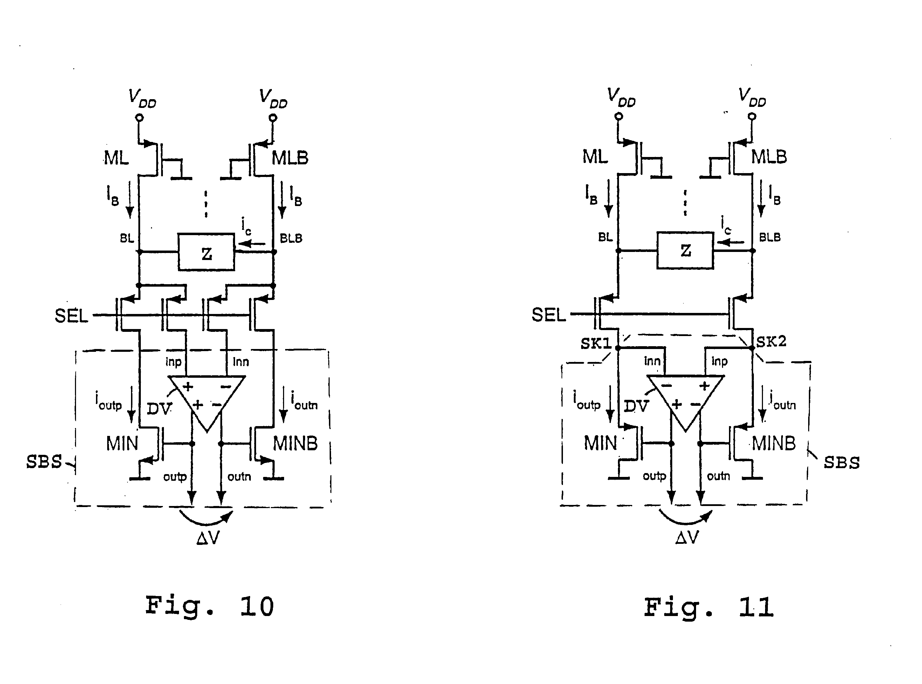

Weitere Ausführungsbeispiele welche eine Zusatzbeschaltung mit einem Bitleitungsmultiplexer und einer Schaltung zum Reduzieren der Zeitdauer beim Lesezugriff auf die Speicherzelle aufweisen, welche insbesondere durch die Multiplexerschaltung erhöht wird, sind in den Figuren 10 und 11 gezeigt. Eine Leseverstärkerschaltung LV ist in der Regel größer als die Breite einer Speicherzelle Z. Daher sind einer Leseverstärkerschaltung generell mehrere Bitleitungen zugeordnet, von denen jeweils eine durch eine Multiplexerschaltung, welche im Prinzip mehrere Schalter aufweist, an die Leseverstärkerschaltung geschaltet wird. Die Multiplexerschaltung weist einen Widerstand auf, der in Reihe zum Eingangswiderstand der Leseverstärkerschaltung bzw. der Strombewerterschaltung liegt. Die Multiplexerschaltung hat dadurch einen wesentlichen Einfluss auf das Zeitverhalten beim Lesezugriff auf die Speicherzelle. Durch die Schaltung zum Reduzieren dieser durch die Multiplexerschaltung bedingten Zeitverzögerung kann diese Zeitverzögerung reduziert werden. Eine derartige Schaltungsanordnung zum Reduzieren dieser Zeitdauer beim Lesezugriff auf den Speicher ist in der deutschen Offenlegungsschrift DE 100 23 362 A1 offenbart, welche hiermit vollständig in den Offenbarungsgehalt der Anmeldung aufgenommen wird.

In Fig. 10 ist eine Schaltung angegeben bei welcher die Drain-Anschlüsse der Transistoren MIN und MINB sowie die Eingänge inp und inn der differentiellen Strombewerterschaltung SBS jeweils mit einem Drain-Anschluss eines p-Kanal-Transistors elektrisch verbunden ist. Diese vier Transistoren bilden einen Bitleitungsmultiplexer und sind mit ihren Gate-Anschlüssen mit einer Schaltung zur Reduzierung der Zeitdauer beim Lesezugriff auf die Speicherzelle Z bzw. ein Speicherzellenfeld mit mehreren Speicherzellen Z verbunden. Durch diese Schaltung zum Reduzieren dieser Zeitverzögerung beim Lesezugriff auf die Speicherzelle Z wird ein Signal SEL erzeugt, wodurch die vier Transistoren des Bitleitungsmultiplexers gesteuert werden.

Ein weiteres Ausführungsbeispiel ist in Fig. 11 gezeigt. Die Multiplexerschaltung ist in diesem Ausführungsbeispiel aus zwei p-Kanal-Transistoren aufgebaut, welche mit ihren Gate-Anschlüssen mit dem Signal SEL gesteuert werden. Einer der beiden Transistoren ist mit seinem Drain-Anschluss mit dem Schaltungsknoten SK1 und der zweite Transistor mit seinem Drain-Anschluss mit dem Schaltungsknoten SK2 elektrisch verbunden.

Neben den in den Figuren dargestellten Ausführungsbeispielen, kann darüber hinaus eine Mehrzahl an weiteren erfindungsgemäßen Schaltungsanordnungen zum Auslesen und Bewerten eines Speicherzustandes in einer Halbleiterspeicherzelle, insbesondere einer SRAM-Speicherzelle, realisiert werden. Ein wesentlicher Bestandteil einer derartigen Schaltungsanordnung kann die erfindungsgemäße differentielle Strombewerterschaltung sein. Diese differentiell aufgebaute Strombewerterschaltung weist einen Differenzverstärker auf, dessen Ausgänge über Mittel zum Einstellen des Eingangswiderstandes des Differenzverstärkers mit dessen Eingängen und den Signalleitungen, zwischen denen eine Spannungsdifferenz durch den Differenzverstärker ermittelt wird und durch die differentielle Strombewerterschaltung ein entsprechender Strom bewertet wird, elektrisch verbunden. Durch diesen Aufbau und die Beschaltung arbeitet die differentielle Strombewerterschaltung sehr schnell und ihr benötigter Flächenbedarf ist relativ gering. Besonders bei der Verwendung einer differentiellen Strombewerterschaltung zum Auslesen einer an die Bitleitungen angeschlossenen SRAM-Speicherzelle, ist damit ein sehr schnelles Bewerten möglich, wenn an die Bitleitungen eine Vielzahl von weiteren Speicherzellen angeschlossen sind. Der Differenzverstärker bzw. die differentielle Strombewerterschaltung kann darüber hinaus in erfinderischer Weise durch Schaltungsteile zum Einstellen des Arbeitspunktes des Differenzverstärkers und/oder durch einen Schaltungsteil zum Deaktivieren des Differenzverstärkers bzw. der differentiellen Strombewerterschaltung und/oder einem Schaltungsteil zum Aktivieren des Differenzverstärkers bzw. der differentiellen Strombewerterschaltung ergänzt werden.

Die Spannungsdifferenz zwischen zwei Signalleitungen kann auch direkt durch eine erfinderische Leseverstärkerschaltung detektiert werden, deren Eingänge mit den beiden Signalleitungen verbunden ist. In diesem Falle wird am Ausgang der Leseverstärkerschaltung keine dem Strom entsprechende Spannungsdifferenz zur Verfügung gestellt, sondern die direkt zwischen den Signalleitungen auftretende Spannung als logisches Signal zur Verfügung gestellt. Durch die erfindungsgemäße Beschaltung der Leseverstärkerschaltung kann am Ausgang die detektierte Spannungsdifferenz zeitlich kontinuierlich zur Verfügung gestellt werden, unabhängig davon, ob die Spannungen auf den beiden Signalleitungen auf 0 gesetzt werden oder nicht. Bevorzugt wird die Leseverstärkerschaltung in einer Schaltungsanordnung zum Auslesen und Bewerten des Speicherzustandes einer Speicherzelle verwendet, wobei in diesem Falle keine Strombewerterschaltung der Leseverstärkerschaltung vorgeschaltet sein muss. Dadurch ist es möglich, eine sichere und stetige Weiterverarbeitung des Ausgangssignals der Leseverstärkerschaltung zu gewährleisten.

Wird eine Schaltungsanordnung zum Auslesen und Bewerten eines Speicherzustandes einer Halbleiterspeicherzelle aus einer SRAM-Speicherzelle, einer Strombewerterschaltung und einer Leseverstärkerschaltung aufgebaut, so zeichnet sich eine mögliche Ausführung einer erfinderischen Schaltungsanordnung dadurch aus, dass die Strombewerterschaltung entsprechend der erfindungsgemäßen differentiellen Strombewerterschaltung ausgebildet ist und mit einer bekannten Leseverstärkerschaltung kombiniert wird. Vorteilhaft kann diese Schaltungsanordnung mit einem Schaltungsteil zum automatischen Deaktivieren der Strombewerterschaltung kombiniert werden. Durch die Verwendung eines derartigen Schaltungsteils zum automatischen Deaktivieren wird ein reduzierter Leistungsverbrauch der Schaltungsanordnung, insbesondere der Strombewerterschaltung, dadurch erreicht, indem die Strombewerterschaltung zeitlich optimiert betrieben wird und somit unmittelbar vor einem Lesevorgang aktiviert und unmittelbar nach Beenden des Lesevorgangs wieder deaktiviert wird.

Eine weitere mögliche erfinderische Kombination einer derartigen Schaltungsanordnung ergibt sich aus einer Kombination einer bekannten Strombewerterschaltung mit einer der Strombewerterschaltung nachgeschalteten erfinderischen Leseverstärkerschaltung. Insbesondere dann, wenn die Strombewerterschaltung deaktiviert wird, wird dadurch auch nach einem Deaktivieren eine weitere Verarbeitung des Ausgangssignals der Leseverstärkerschaltung ermöglicht. Dies kann dadurch gewährleistet werden, da die erfindungsgemäße Leseverstärkerschaltung auch nach dem Deaktivieren der Strombewerterschaltung noch die gelesene Information in Form dieses Ausgangssignals der Leseverstärkerschaltung zur Verfügung stellt. Besonders vorteilhaft ist es auch bei dieser Kombination die Schaltungsanordnung in erfinderischer Weise durch einen Schaltungsteil zum automatischen Deaktivieren der Strombewerterschaltung zu erweitern. Durch entsprechende Beschaltung der Strombewerterschaltung mit dem Schaltungsteil zum automatischen Deaktivieren der Strombewerterschaltung ist auch in diesem Falle ein automatischen Deaktivieren möglich, wobei die Beschaltung insbesondere dann aufwandsarm realisiert werden kann, wenn die Strombewerterschaltung Mittel zum Deaktivieren aufweist.

Die besonders bevorzugte Ausführung der Schaltungsanordnung kennzeichnet sich durch eine Kombination der erfindungsgemäßen differentiellen Strombewerterschaltung mit der erfindungsgemäßen Leseverstärkerschaltung, da bei dieser Kombination die Zeitdauer zur Erfassung und Bewertung eines Speicherzustandes minimiert werden kann. Der sehr geringe Leistungsverbrauch dieser erfindungsgemäßen Schaltungsanordnung kann in diesem Fall weiter dadurch reduziert werden, dass eine automatische Deaktivierung der differentiellen Strombewerterschaltung durch eine aufwandsarme Zusatzbeschaltung der Schaltungsanordnung durch den Schaltungsteil zum automatischen Deaktivieren erreicht wird.

Dieses erfinderische Konzept der automatischen Deaktivierung einer Strombewerterschaltung mittels einer geeigneten zusätzlichen Beschaltung wie sie durch den Schaltungsteil STAD möglich ist, kann auch bei einer derartigen Schaltungsanordnung zum Auslesen und Bewerten eines Speicherzustandes in einer SRAM-Speicherzelle verwendet werden, bei der weder die Leseverstärkerschaltung noch die Strombewerterschaltung entsprechend der erfindungsgemäßen Leseverstärkerschaltung bzw. der erfindungsgemäßen Strombewerterschaltung ausgebildet sind. Die Strombewerterschaltung kann in diesem Fall Mittel zum Deaktivieren aufweisen oder durch geeignete Beschaltung dieser Strombewerterschaltung mit dem Schaltungsteil STAD deaktiviert werden, wodurch auch bei bekannten Schaltungsanordnungen, insbesondere mit einer SRAM-Speicherzelle, einer Strombewerterschaltung und einer Leseverstärkerschaltung eine optimierte Betriebszeit bzw. aktive Zeit der Strombewerterschaltung erreicht werden kann. Dadurch ist auch eine wesentliche Reduzierung des Leistungsverbrauchs der Schaltungsanordnung, insbesondere der Stromberwerterschaltung möglich.

In allen Ausführungsbeispielen in denen das Konzept der automatischen Deaktivierung verwendet wird, kann durch das automatische Deaktivieren in vorteilhafter Weise gewährleistet werden, dass auch ein Fehlverhalten durch vorzeitiges Abschalten der Strombewerterschaltung verhindert wird, da die Deaktivierung in Falle eines automatischen Durchführens des Deaktivierens erst erfolgen kann, wenn der der Strombewerterschaltung nachgeschaltete Leseverstärker den Lesevorgang beendet hat.

Für das Auslesen und Bewerten eines Speicherzustandes einer Speicherzelle ist somit eine Mehrzahl an erfinderischen Kombinationen zur Realisierung einer dafür vorgesehenen Schaltungsanordnung möglich, welche jeweils durch das erfinderische Konzept der automatischen Deaktivierung insbesondere der Strombewerterschaltung ergänzt werden können.

**Patentansprüche**

1. Differentielle Strombewerterschaltung mit

   - einem Differenzverstärker (DV) mit einem ersten Eingang (inp), welcher ein erster Eingang der differentiellen Strombewerterschaltung (SBS) ist, wobei der erste Eingang (inp) mit einer ersten Signalleitung (BL) eines Datenleitungspaares elektrisch verbunden ist und einem zweiten Eingang (inn), welcher ein zweiter Eingang der differentiellen Strombewerterschaltung (SBS) ist, wobei der zweite Eingang (inn) mit einer zweiten Signalleitung (BLB) des Datenleitungspaares elektrisch verbunden ist,
   - Mitteln (MIN, MINB) zum Einstellen eines Eingangswiderstands der Strombewerterschaltung (SBS), wobei diese Mittel (MIN, MINB) mit Ausgängen (outp, outn) und den Eingängen (inp, inn) des Differenzverstärkers (DV) und mit den Signalleitungen (BL, BLB) des Datenleitungspaares elektrisch verbunden sind.

2. Differentielle Strombewerterschaltung nach Anspruch 1, **dadurch gekennzeichnet, dass** die Mittel zum Einstellen des Eingangswiderstands zwei Transistoren (MIN, MINB) eines ersten Leitungstyps sind,

   - wobei der erste Transistor (MIN) mit einem ersten Ausgang (outp) und dem ersten Eingang (inp) des Differenzverstärkers (DV) und mit der ersten Signalleitung (BL) und
   - der zweite Transistor (MINB) mit einem zweiten Ausgang (outn) und dem zweiten Eingang (inn) des Differenzverstärkers (DV) und der zweiten Signalleitung (BLB) elektrisch verbunden ist.

3. Differentielle Strombewerterschaltung nach Anspruch 2, **dadurch gekennzeichnet, dass**

   - der erste Transistor (MIN) mit seinem Gate-Anschluss mit dem ersten Ausgang (outp) des Differenzverstärkers (DV), mit einem ersten Anschluss mit der ersten Signalleitung (BL) des Datenleitungspaares und mit einem zweiten Anschluss mit Massepotenzial elektrisch verbunden ist und
   - der zweite Transistor (MINB) mit seinem Gate-Anschluss mit dem zweiten Ausgang (outn) des Differenzverstärkers (DV), mit einem ersten Anschluss mit der zweiten Signalleitung (BLB) des Datenleitungspaares und mit einem zweiten Anschluss mit Massepotenzial elektrisch verbunden ist.

4. Differentielle Strombewerterschaltung nach einem der vorhergehenden Ansprüche, **dadurch gekennzeichnet, dass** der Differenzverstärker (DV) zwei parallel geschaltete Schaltungszweige (SZW1, SZW2) aufweist, wobei in jedem der beiden Schaltungszweige (SZW1, SZW2) ein Transistor (MINN, MINP) eines ersten Leitungstyps und ein Transistor (MLP, MLN) eines zweiten Leitungstyps in Reihe geschaltet sind.

5. Differentielle Strombewerterschaltung nach Anspruch 4, **dadurch gekennzeichnet, dass** der Transistor (MINN) des ersten Leitungstyps im ersten Schaltungszweig (SZW1) mit seinem Gate-Anschluss mit dem zweiten Eingang (inn) des Differenzverstärkers (DV) und der Transistor (MINP) des ersten Leitungstyps im zweiten Schaltungszweig (SZW2) mit seinem Gate-Anschluss mit dem ersten Eingang (inp) des Differenzverstärkers (DV) elektrisch verbunden ist.

6. Differentielle Strombewerterschaltung nach einem der Ansprüche 4 oder 5, **dadurch gekennzeichnet, dass** die beiden Schaltungszweige (SZW1, SZW2) jeweils mit einem Ende an ein Versorgungsspannungspotenzial ($V_{DD}$) geführt sind und mit dem jeweils anderen Ende mit einem ersten Anschluss eines in Reihe zu den Schaltungszweigen (SZW1, SZW2) geschalteten Transistors (MB1), welcher den ersten Leitungstyp aufweist, elektrisch verbunden sind.

7. Differentielle Strombewerterschaltung nach einem der vorhergehenden Ansprüche, **gekennzeichnet durch**, einen Schaltungsteil (SAP) zum Einstellen des Arbeitspunkts des Differenzverstärkers (DV), welcher zumindest zwei elektrische Verbindungen mit dem Differenzverstärker (DV) aufweist.

8. Differentielle Strombewerterschaltung nach Anspruch 7, **dadurch gekennzeichnet, dass** der Schaltungsteil (SAP) zum Einstellen des Arbeitspunkts einen ersten Transistor (MB4) des zweiten Leitungstyps aufweist, welcher mit seinem Gate-Anschluss mit einem ersten (SZW1) und einem zweiten (SZW2) Schaltungszweig des Differenzverstärkers (DV), insbesondere mit dem Gate-Anschluss eines Transistors (MLP) eines zweiten Leitungstyps im ersten Schaltungszweig (SZW1) und dem Gate-Anschluss eines Transistors (MLN) eines zweiten Leitungstyps im zweiten Schaltungszweig (SZW2), elektrisch verbunden ist.

9. Differentielle Strombewerterschaltung nach einem der Ansprüche 7 oder 8,

**dadurch gekennzeichnet, dass**
der Schaltungsteil (SAP) zum Einstellen des Arbeitspunkts einen Transistor (MB2) des ersten Leitungstyps aufweist, dessen Gate-Anschluss mit dem Gate-Anschluss eines Transistors (MB1) eines ersten Leitungstyps des Differenzverstärkers (DV) elektrisch verbunden ist, wobei dieser Transistor (MB1) des Differenzverstärkers (DV) in Reihe zu den Schaltungszweigen (SZW1, SZW2) des Differenzverstärkers (DV) geschaltet ist.

10. Differentielle Strombewerterschaltung nach einem der Ansprüche 7 bis 9,
    **dadurch gekennzeichnet, dass**
    der Schaltungsteil (SAP) zum Einstellen des Arbeitspunkts einen zweiten Transistor (MB3) des zweiten Leitungstyps aufweist, dessen Gate-Anschluss mit einem dritten Eingang (PD) der Strombewerterschaltung (SBS) elektrisch verbunden ist.

11. Differentielle Strombewerterschaltung nach den Ansprüchen 8 bis 10,
    **dadurch gekennzeichnet, dass**

    - der erste Transistor (MB4) des zweiten Leitungstyps mit einem ersten Anschluss mit einem Versorgungsspannungspotenzial ($V_{DD}$) verbunden ist und mit einem zweiten Anschluss eine elektrische Verbindung mit seinem eigenen Gate-Anschluss sowie mit einem ersten Anschluss des zweiten Transistors (MB3) des zweiten Leitungstyps aufweist,
    - der zweite Transistor (MB3) des zweiten Leitungstyps mit einem zweiten Anschluss mit dem zweiten Anschluss des Transistors (MB2) des ersten Leitungstyps elektrisch verbunden ist, und
    - der Transistor (MB2) des ersten Leitungstyps mit dem zweiten Anschluss mit seinem Gate-Anschluss rückgekoppelt ist und mit einem ersten Anschluss mit Massepotenzial verbunden ist.

12. Differentielle Strombewerterschaltung nach einem der vorhergehenden Ansprüche,
    **gekennzeichnet durch**
    einen Schaltungsteil (STD) zum Deaktivieren des Differenzverstärkers (DV), wobei dieser Schaltungsteil (STD) zumindest mit den Ausgängen (outp, outn) des Differenzverstärkers (DV) und mit dem dritten (PD) und einem vierten (PDn) Eingang der Strombewerterschaltung (SBS) elektrisch verbunden ist.

13. Differentielle Strombewerterschaltung nach Anspruch 12, **dadurch gekennzeichnet, dass**
    der Schaltungsteil (STD) zum Deaktivieren des Differenzverstärkers (DV)

- einen ersten Transistor (MPD1) des ersten Leitungstyps aufweist, welcher mit dem ersten Ausgang (outp) des Differenzverstärkers (DV) und mit dem dritten Eingang (PD) der Strombewerterschaltung (SBS) verbunden ist,
- zumindest einen zweiten Transistor (MPD2) des ersten Leitungstyps aufweist, welcher mit dem zweiten Ausgang (outn) des Differenzverstärkers (DV) und mit dem dritten Eingang (PD) der Strombewerterschaltung (SBS) verbunden ist,
- einen ersten Transistor (MB3) des zweiten Leitungstyps aufweist, welcher mit seinem Gate-Anschluss mit dem dritten Eingang (PD) der Strombewerterschaltung (SBS) elektrisch verbunden ist, und
- einem zweiten Transistor (MPD3) des zweiten Leitungstyps aufweist, welcher mit dem vierten Eingang (PDn) der Strombewerterschaltung (SBS) elektrisch verbunden ist.

14. Differentielle Strombewerterschaltung nach Anspruch 13, **dadurch gekennzeichnet, dass**
    die beiden Transistoren (MPD1, MPD2) des ersten Leitungstyps mit ihren Gate-Anschlüssen mit dem dritten Eingang (PD) der Strombewerterschaltung (SBS) und mit jeweils ersten Anschlüssen mit Massepotenzial verbunden sind und der erste Transistor (MPD1) des ersten Leitungstyps mit einem zweiten Anschluss mit dem ersten Ausgang (outp) des Differenzverstärkers (DV) und der zweite Transistor (MPD2) des ersten Leitungstyps mit einem zweiten Anschluss mit dem zweiten Ausgang (outn) des Differenzverstärkers (DV) elektrisch verbunden ist.

15. Differentielle Strombewerterschaltung nach einem der Ansprüche 13 oder 14,
    **dadurch gekennzeichnet, dass**
    der zweite Transistor (MPD3) des zweiten Leitungstyps des Schaltungsteils (STD) zum Deaktivieren des Differenzverstärkers (DV) mit seinem Gate-Anschluss mit dem vierten Eingang (PDn) der Strombewerterschaltung (SBS), mit einem ersten Anschluss an Versorgungsspannungspotenzial ($V_{DD}$) anliegt und mit einem zweiten Anschluss mit den beiden Schaltungszweigen (SZW1, SZW2), insbesondere mit den Gate-Anschlüssen von Transistoren (MLP, MLN) eines zweiten Leitungstyps, von denen jeweils einer in einem Schaltungszweig (SZW1, SZW2) des Differenzverstärkers (DV) angeordnet ist.

16. Differentielle Strombewerterschaltung nach einem der Ansprüche 7 bis 11 und einem der Ansprüche 12 bis 15,
    **dadurch gekennzeichnet, dass**
    die Schaltungsteile zum Einstellen des Arbeitspunkts (SAP) und zum Deaktivieren (STD) des Differenzverstärkers (DV) derart verschaltet sind, dass sie zumindest ein gemeinsames Bauelement aufweisen, welches beiden Schaltungsteilen (SAP, STD) zugeordnet ist, wobei dieses Bauelement in dem Schaltungsteil (SAP) zum Einstellen des Arbeitspunktes der zweite Transistor (MB3) des zweiten Leitungstyps bzw. im Schaltungsteil (STD) zum Deaktivieren des Differenzverstärkers (DV) der erste Transistor (MB3) des zweiten Leitungstyps ist.

17. Differentielle Strombewerterschaltung nach einem der vorhergehenden Ansprüche,
    **gekennzeichnet durch**
    einen Schaltungsteil (STA) zum Aktivieren des Differenzverstärkers (DV), welcher mit den beiden Ausgängen (outp, outn) des Differenzverstärkers (DV) und mit einem fünften (PRECH) und einem sechsten (PRECHn) Eingang der Strombewerterschaltung (SBS) elektrisch verbunden ist.

18. Differentielle Strombewerterschaltung nach Anspruch 17, **dadurch gekennzeichnet, dass**
    der Schaltungsteil (STA) zumindest zwei Transistoren (MPREn1, MPREn2) eines ersten Leitungstyps aufweist, wobei

    - einer der Transistoren (MPREnl) des ersten Leitungstyps mit einem ersten Anschluss mit dem ersten Ausgang (outp) des Differenzverstärkers (DV) und

    - der andere Transistor (MPREn2) des ersten Leitungstyps mit einem ersten Anschluss mit dem zweiten Ausgang (outn) des Differenzverstärkers (DV) elektrisch verbunden ist,

    - die beiden Transistoren (MPREn1, MPREn2) des ersten Leitungstyps jeweils mit zweiten Anschlüssen an Versorgungsspannungspotenzial ($V_{DD}$) anliegen und mit ihren Gate-Anschlüssen mit dem fünften Eingang (PRECH) der Strombewerterschaltung (SBS) verbunden sind.

19. Differentielle Strombewerterschaltung nach einem der Ansprüche 17 oder 18,
    **dadurch gekennzeichnet, dass**
    der Schaltungsteil (STA) zumindest zwei Transistoren (MPREp1, MPREp2) eines zweiten Leitungstyps aufweist, wobei

    - die beiden Transistoren (MPREp1, MPREp2) des zweiten Leitungstyps jeweils mit ersten Anschlüssen mit einem Spannungspotenzial, insbesondere mit dem Potenzial des Gate-Anschlusses des ersten Transistors (MB4) des zweiten Leitungstyps des Schaltungsteils zum Einstellen des Arbeitspunktes des Differenzverstärkers (DV), und mit ihren Gate-Anschlüssen mit dem sechsten Eingang (PRECHn) der Strombewerterschaltung (SBS) verbunden sind und

    - einer der Transistoren (MPREp1) mit einem zweiten Anschluss mit dem ersten Ausgang (outp) des Differenzverstärkers (DV) und der andere Transistor (MPREp2) mit einem zweiten Anschluss mit dem zweiten Ausgang (outn) des Differenzverstärkers (DV) elektrisch verbunden ist.

20. Leseverstärkerschaltung mit einem ersten und einem zweiten Schaltungsteil,

    - wobei der erste Schaltungsteil (ST1) zwei kreuzgekoppelte Inverter aufweist und einer der Inverter mit einem ersten (SO) und der zweite Inverter mit einem zweiten Ausgang (SON) der Leseverstärkerschaltung (LV) elektrisch verbunden ist,

    - jeder Inverter einen Transistor (M2, M5) eines zweiten Leitungstyps aufweist und jedem dieser beiden Transistoren ($M^2$, M5) ein weiterer Transistor (M1, M6) des zweiten Leitungstyps parallel geschaltet ist, wobei die Gate-Anschlüsse dieser weiteren Transistoren (M1, M6) mit einem ersten Eingang (SAEN) der Leseverstärkerschaltung verbunden sind,

    - der zweite Schaltungsteil (ST2) einen ersten und einen zweiten Schaltungszweig aufweist und der erste Schaltungszweig mit dem ersten Inverter und der zweite Schaltungszweig mit dem zweiten Inverter des ersten Schaltungsteils elektrisch verbunden ist, und

    - der zweite Schaltungsteil einen Transistor (M9) aufweist, dessen erster Anschluss mit Massepotenzial und dessen zweiter Anschluss mit den beiden Schaltungszweigen elektrisch verbunden ist,

    **dadurch gekennzeichnet, dass**
    der zweite Schaltungsteil (ST2) einen ersten und einen zweiten Schaltungszweig mit jeweils zwei Transistoren (M4, MH1; M8, MH2) aufweist und die Transistoren (M4, MH1; M8, MH2) in den beiden Schaltungszweigen parallel geschaltet sind.

21. Leseverstärkerschaltung nach Anspruch 20,
    **dadurch gekennzeichnet, dass**
    die Transistoren (M4, MH1; M8, MH2) in den beiden Schaltungszweigen von einem ersten Leitungstyps sind.

22. Leseverstärkerschaltung nach einem der Ansprüche 20 oder 21,
    **dadurch gekennzeichnet, dass**

    - der Gate-Anschluss des ersten Transistors (M4) des ersten Schaltungszweigs mit einem zweiten Eingang (NN) der Leseverstärkerschaltung (LV) elektrisch verbunden ist und

- der Gate-Anschluss des zweiten Transistors (MH1) des ersten Schaltungszweigs ein Eingangssignal mit einem dritten Eingang (HOLD) der Leseverstärkerschaltung (LV) verbunden ist,
- der Gate-Anschluss des ersten Transistors (M8) des zweiten Schaltungszweigs mit einem vierten Eingangs (NP) der Leseverstärkerschaltung (LV) verbunden ist und
- der Gate-Anschluss des zweiten Transistors (MH2) des zweiten Schaltungszweigs mit dem dritten Eingang (HOLD) der Leseverstärkerschaltung (LV) elektrisch verbunden ist.

23. Schaltungsanordnung zum Auslesen und Bewerten eines Speicherzustands einer Halbleiterspeicherzelle, insbesondere einer SRAM-Speicherzelle, wobei die Halbleiterspeicherzelle (Z) mit einem Anschluss mit einer ersten Datenleitung (BL) eines Datenleitungspaares und mit einem zweiten Anschluss mit einer zweiten Datenleitung (BLB) des Datenleitungspaares elektrisch verbunden ist, mit

- einer differentiellen Strombewerterschaltung (SBS) nach einem der Ansprüche 1 bis 19 ,
- einer Leseverstärkerschaltung (LV), die der differentiellen Strombewerterschaltung (SBS) nachgeschaltet ist.

24. Schaltungsanordnung nach Anspruch 23, **gekennzeichnet durch** eine Leseverstärkerschaltung (LV) nach einem der Ansprüche 20 bis 22.

25. Schaltungsanordnung zum Auslesen und Bewerten eines Speicherzustands einer Halbleiterspeicherzelle, insbesondere einer SRAM-Speicherzelle, wobei die Halbleiterspeicherzelle (Z) mit einem Anschluss mit einer ersten Datenleitung (BL) eines Datenleitungspaares und mit einem zweiten Anschluss mit einer zweiten Datenleitung (BLB) des Datenleitungspaares elektrisch verbunden ist, mit

- einer Strombewerterschaltung (SBSA; SBS), insbesondere einer differentiellen Strombewerterschaltung, insbesondere mit Mitteln zum Deaktivieren der Strombewerterschaltung, und
- einer Leseverstärkerschaltung (LV) nach einem der Ansprüche 20 bis 22, die der Strombewerterschaltung (SBSA; SBS) nachgeschaltet ist.

26. Schaltungsanordnung nach Anspruch 25, **dadurch gekennzeichnet, dass** die Strombewerterschaltung eine differentielle Strombewerterschaltung (SBS) nach einem der Ansprüche 1 bis 19 ist.

27. Schaltungsanordnung nach einem der Ansprüche 23 bis 26, **gekennzeichnet durch** einen Schaltungsteil (STAD) zum automatischen Deaktivieren der Strombewerterschaltung (SBS; SBSA) nach einem Lesevorgang, wobei der Schaltungsteil (STAD) zum automatischen Deaktivieren zumindest mit einem Ausgang (SO, SON) der Leseverstärkerschaltung (LV) und zumindest mit einem Eingang der Strombewerterschaltung (SBSA, SBS) elektrisch verbunden ist.

28. Schaltungsanordnung nach Anspruch 27, **dadurch gekennzeichnet, dass** der Schaltungsteil (STAD) zum automatischen Deaktivieren mit dem dritten (PD) und dem vierten (PDn) der differentiellen Strombewerterschaltung (SBS) elektrisch verbunden ist.

29. Schaltungsanordnung nach einem der Ansprüche 27 oder 28, **dadurch gekennzeichnet, dass** der Schaltungsteil (STAD) zum automatischen Deaktivieren eine Reihenschaltung aus einem NAND-Gatter, einem Inverter (I) und einem Flip-Flop (FF) aufweist.

30. Schaltungsanordnung nach Anspruch 29, **dadurch gekennzeichnet, dass** die Eingänge des NAND-Gatters mit den Ausgängen der Leseverstärkerschaltung (LV) verbunden sind, ein Ausgang des Flip-Flops (FF) mit dem vierten Eingang (PDn) der differentiellen Strombewerterschaltung (SBS) und ein zweiter Ausgang des Flip-Flops (FF) mit dem dritten Eingang (PD) der differentiellen Strombewerterschaltung (SBS) und dem dritten Eingang (HOLD) der Leseverstärkerschaltung (LV) elektrisch verbunden ist.

31. Schaltungsanordnung zum Auslesen und Bewerten eines Speicherzustands einer Halbleiterspeicherzelle, insbesondere einer SRAM-Speicherzelle, wobei die Halbleiterspeicherzelle (Z) mit einem Anschluss mit einer ersten Datenleitung (BL) eines Datenleitungspaares und mit einem zweiten Anschluss mit einer zweiten Datenleitung (BLB) des Datenleitungspaares elektrisch verbunden ist, mit

- einer Strombewerterschaltung (SBSA), insbesondere einer differentiellen Strombewerterschaltung, insbesondere mit Mitteln zum Deaktivieren der Strombewerterschaltung, und
- einer Leseverstärkerschaltung (LV) die der Strombewerterschaltung (SBSA) nachgeschaltet ist,

**gekennzeichnet durch**

einen Schaltungsteil (STAD) zum automatischen Deaktivieren der Strombewerterschaltung (SBSA) nach einem Lesevorgang, wobei der Schaltungsteil (STAD) zum automatischen Deaktivieren zumindest mit einem Ausgang (SO, SON) der Leseverstärkerschaltung (LV) und zumindest mit einem Eingang der Strombewerterschaltung (SBSA) elektrisch verbunden ist.

**32.** Schaltungsanordnung nach einem der Ansprüche 27 oder 28, **dadurch gekennzeichnet, dass** der Schaltungsteil (STAD) zum automatischen Deaktivieren eine Reihenschaltung aus einem NAND-Gatter, einem Inverter (I) und einem Flip-Flop (FF) aufweist.

**33.** Schaltungsanordnung nach Anspruch 29, **dadurch gekennzeichnet, dass** die Eingänge des NAND-Gatters mit den Ausgängen der Leseverstärkerschaltung (LV) verbunden sind und das Flip-Flop (FF) zumindest einen Ausgang aufweist, der mit einem Eingang der Strombewerterschaltung (SBSA) elektrisch verbunden ist.

Fig. 2
(Stand der Technik)

Fig. 1
(Stand der Technik)

Fig. 4

(Stand der Technik)

Fig. 3

(Stand der Technik)

Fig. 5

Fig. 6

Fig. 7

Fig. 8

Fig. 9

EP 1 365 413 A2

Fig. 11

Fig. 10